(19) Europäisches Patentamt / European Patent Office / Office européen des brevets

(11) **EP 3 005 568 B1**

(12) **FASCICULE DE BREVET EUROPEEN**

(45) Date de publication et mention de la délivrance du brevet:
**05.07.2017 Bulletin 2017/27**

(21) Numéro de dépôt: **14725180.5**

(22) Date de dépôt: **20.05.2014**

(51) Int Cl.:
*H03L 7/24* (2006.01)    *H03L 7/18* (2006.01)
*H03B 21/02* (2006.01)

(86) Numéro de dépôt international:
**PCT/EP2014/060362**

(87) Numéro de publication internationale:
**WO 2014/191259 (04.12.2014 Gazette 2014/49)**

(54) **DISPOSITIF DE GENERATION DE SIGNAUX STABLES EN FREQUENCE A OSCILLATEUR VERROUILLE PAR INJECTION COMMUTABLE**

VORRICHTUNG ZUR ERZEUGUNG FREQUENZSTABILER SIGNALE MT EINEM UMSCHALTBARER INJEKTIONSSYNCHRONISIERTEN OSZILLATOR

DEVICE FOR GENERATING FREQUENCY-STABLE SIGNALS WITH SWITCHABLE INJECTION-LOCKED OSCILLATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.05.2013 FR 1354754**

(43) Date de publication de la demande:
**13.04.2016 Bulletin 2016/15**

(73) Titulaire: **Commissariat à l'Énergie Atomique et aux Énergies Alternatives**
**75015 Paris (FR)**

(72) Inventeurs:
• **GONZALEZ JIMENEZ, José-Luis**
  **F-38340 Voreppe (FR)**
• **SILIGARIS, Alexandre**
  **F-38100 Grenoble (FR)**

(74) Mandataire: **Brevalex**
**95, rue d'Amsterdam**
**75378 Paris Cedex 8 (FR)**

(56) Documents cités:
**EP-A2- 1 931 033**    **US-A1- 2008 285 625**
**US-A1- 2012 161 827**

• **JEONGMIN YANG ET AL: "A 7 mW 2.5 GHz spread spectrum clock generator using switch-controlled injection-locked oscillator", CIRCUITS AND SYSTEMS (ISCAS), 2013 IEEE INTERNATIONAL SYMPOSIUM ON, IEEE, 19 mai 2013 (2013-05-19), pages 1392-1395, XP032446188, DOI: 10.1109/ISCAS.2013.6572115 ISBN: 978-1-4673-5760-9**

EP 3 005 568 B1

**Description**

**DOMAINE TECHNIQUE**

L'invention concerne le domaine des dispositifs de génération de signaux stables en fréquence, utilisés par exemple au sein de dispositifs émetteurs - récepteurs, et notamment dans des dispositifs émetteurs - récepteurs RF sans fil intégrés faisant appel à plusieurs signaux stables en fréquence dans les parties émission et réception de ces dispositifs, par exemple pour réaliser simultanément une émission et une réception de signaux dans au moins deux bandes de fréquences différentes.

L'invention est avantageusement utilisée dans des dispositifs émetteurs - récepteurs de type FDD (« Frequency Division Duplexing ») par exemple adaptés au standard de communication E-Band.

**ÉTAT DE LA TECHNIQUE ANTÉRIEURE**

Certains dispositifs émetteurs - récepteurs font appel à plusieurs signaux stables en fréquence pour réaliser simultanément une émission et une réception de signaux. Lorsque l'émission doit être réalisée dans une première bande de fréquences et que la réception doit être réalisée dans une deuxième bande de fréquences différente de la première bande, un tel dispositif comporte généralement deux générateurs de signaux distincts permettant de générer chacun un signal stable en fréquence adapté à l'émission ou la réception dans la bande de fréquences correspondante, les deux signaux générés étant de fréquences différentes.

De plus, il peut être nécessaire, pour certains standards de communication, de pouvoir permuter les bandes de fréquences d'émission et de réception, ce qui nécessite soit de pouvoir délivrer chacun des signaux générés vers les parties émission et réception du dispositif, soit de pouvoir changer rapidement les valeurs des fréquences des signaux générés. Par exemple, dans le cas d'un dispositif émetteur - récepteur de type « E-Band », deux bandes de fréquences de 5 GHz autour de 70 GHz et de 80 GHz sont utilisées pour l'émission et la réception de signaux. De plus, un tel dispositif doit pouvoir permuter ces deux bandes de fréquences pour l'émission et la réception.

Le document de O. Katz et al., « A fully integrated SiGe E-BAND transceiver chipset for broadband point-to-point communication », Radio and Wireless Symposium (RWS), 2012 IEEE, pages 431-434, 15-18 janvier 2012, décrit un dispositif émetteur - récepteur de type FDD adapté au standard de communication E-Band. Pour pouvoir réaliser simultanément une émission et une réception de signaux dans les deux bandes de fréquences différentes et pour pouvoir permuter ces deux bandes, deux générateurs de signaux distincts de type PLL sont utilisés, et un dispositif permettant de permuter l'envoi des signaux de sortie de ces deux générateurs dans les parties émission et réception est utilisé.

Faire appel à deux générateurs de signaux distincts est une solution coûteuse, encombrante et qui consomme beaucoup d'énergie électrique. De plus, dans un tel dispositif, la durée pour réaliser la permutation des bandes de fréquences d'émission et de réception dépend de la durée de verrouillage des PLL, cette durée pouvant être trop importante pour certaines

La publication de brevet US 2008/285625 A1 divulgue un dispositif de génération de fréquences utilisant un multiplexeur pour sélectionner une des fréquences générées par un générateur en fonction des valeurs des signaux de contrôle appliqués respectivement au entrées de contrôle d'un mixer et d'un multiplexer.

**EXPOSÉ DE L'INVENTION**

Un but de la présente invention est de proposer un nouveau type de dispositif permettant de générer au moins un signal de sortie stable en fréquence et de réaliser aisément et rapidement un changement de valeur de la fréquence du signal de sortie, et qui ne présente pas au moins une partie des inconvénients des dispositifs de l'art antérieur.

Pour cela, la présente invention propose un dispositif de génération d'au moins un signal périodique stable en fréquence, comportant au moins :

- un générateur apte à générer au moins un premier signal périodique dont le spectre fréquentiel comporte au moins deux raies à des fréquences $f_a$ et $f_b$ différentes ;
- un premier oscillateur verrouillé par injection commutable apte à recevoir en entrée le premier signal périodique et à se verrouiller, dans un premier état, sur la fréquence $f_a$, et dans un deuxième état, sur la fréquence $f_b$, en fonction de la valeur d'au moins un signal de commande appliqué en entrée du premier oscillateur verrouillé par injection commutable.

Le dispositif selon l'invention fait appel aux propriétés de verrouillage de l'oscillateur verrouillé par injection sur une des fréquences du signal appliqué en entrée de cet oscillateur. L'oscillateur verrouillé par injection commutable est utilisé comme un filtre passe-bande commutable appliqué sur le premier signal périodique dont le spectre fréquentiel comporte au moins deux raies à des fréquences différentes, correspondant donc à un signal multi-tonalités. En fonction de la configuration, ou de l'état de commutation, dans lequel se trouve l'oscillateur verrouillé par injection commutable, le signal de sortie du dispositif comporte alors seulement l'une de ces deux fréquences. Il n'est donc pas nécessaire de faire appel à deux dispositifs distincts pour générer des signaux dans deux bandes de fréquences différentes.

De plus, la commutation du verrouillage sur l'une ou l'autre des fréquences de l'oscillateur verrouillé par injection est plus rapide que pour les dispositifs de l'art antérieur qui nécessitent, à chaque changement de fréquence, le verrouillage d'une PLL sur la nouvelle fréquence.

Les raies aux fréquences $f_a$ et $f_b$ peuvent avoir des amplitudes sensiblement similaires et/ou être en phase l'une avec l'autre et/ou correspondre à deux raies principales du spectre fréquentiel du premier signal périodique. Des raies d'amplitudes similaires et/ou en phase l'une avec l'autre permet au signal périodique stable en fréquence généré d'avoir une amplitude et/ou une phase sensiblement constante quelque soit la fréquence sur laquelle l'oscillateur est verrouillé. Les commutations de l'oscillateur ne modifient pas dans ce cas l'amplitude et/ou la phase du signal de sortie. Le fait que les raies aux fréquences $f_a$ et $f_b$ correspondent à des raies principales du spectre fréquentiel du premier signal périodique facilite le verrouillage de l'oscillateur commutable sur l'une ou l'autre de ces raies et évite un verrouillage de l'oscillateur sur une éventuelle autre raie du spectre fréquentiel du premier signal périodique.

La caractéristique selon laquelle les raies aux fréquences $f_a$ et $f_b$ ont des amplitudes sensiblement similaires peut correspondre à une différence en tension d'environ 4 dB maximum entre ces amplitudes.

Le premier oscillateur verrouillé par injection commutable peut comporter au moins :

- une structure résonante apte à générer un deuxième signal périodique oscillant, dans le premier état, à une première fréquence d'oscillation libre, par exemple proche ou sensiblement égale à $f_a$, et dans le deuxième état, à une deuxième fréquence d'oscillation, par exemple proche ou sensiblement égale à $f_b$, de valeur différente de celle de la première fréquence d'oscillation libre ;
- un élément électrique couplé électriquement à la structure résonante et dont une impédance est équivalente à une résistance électrique négative ;
- un circuit d'injection couplé électriquement au dit élément électrique, recevant en entrée le premier signal périodique et apte à fournir ledit élément électrique avec un courant de fréquence égale à celle du premier signal périodique.

Dans ce cas, la structure résonante du premier oscillateur verrouillé par injection commutable peut comporter au moins un circuit résonant LC comprenant les composants suivants :

- une inductance couplée en parallèle, dans le premier état, à un premier condensateur ou, dans le deuxième état, à un deuxième condensateur ayant une capacité électrique de valeur différente de celle du premier condensateur, ou
- un condensateur couplé en parallèle, dans le premier état, à une première inductance ou, dans le deuxième état, à une deuxième inductance de valeur différente de celle de la première inductance, ou
- dans le premier état, une première inductance couplée en parallèle à un premier condensateur ou, dans le deuxième état, une deuxième inductance couplée en parallèle à un deuxième condensateur, la première inductance ayant une valeur différente de celle de la deuxième inductance et le premier condensateur ayant une capacité électrique de valeur différente de celle du deuxième condensateur,

et pouvant comporter en outre des éléments de commutation aptes à modifier les couplages des composants du circuit résonant LC en fonction du signal de commande.

L'élément électrique du premier oscillateur verrouillé par injection commutable peut comporter une paire croisée différentielle de type MOS, et par exemple formée de deux transistors de type NMOS.

Le circuit d'injection du premier oscillateur verrouillé par injection commutable peut comporter au moins :

- un condensateur comportant une première borne sur laquelle le premier signal périodique est destiné à être appliqué ;
- une résistance comportant une première borne sur laquelle une tension de polarisation continue est destinée à être appliquée et une deuxième borne reliée électriquement à une deuxième borne du condensateur;
- un transistor MOS dont une grille est reliée électriquement à la deuxième borne du condensateur et dont un drain est relié électriquement à l'élément électrique de l'oscillateur verrouillé par injection commutable.

Le générateur peut comporter :

- une boucle à verrouillage de phase délivrant un troisième signal périodique de fréquence $f_1$ et un quatrième signal périodique de fréquence $f_2 = f_1/N_1$, avec $N_1$ supérieur à 1 ;
- un mélangeur de fréquences recevant en entrée le troisième signal périodique et le quatrième signal périodique et délivrant en sortie le premier signal périodique tel $f_a = f_1 - f_2$ et $f_b = f_1 + f_2$.

Un tel générateur est moins coûteux, moins encombrant et consomme moins d'énergie que deux PLL servant à générer deux signaux de fréquences différentes.

En variante, le générateur peut comporter :

- une boucle à verrouillage de phase délivrant un troisième signal périodique de fréquence $f_1$;
- des moyens aptes à recevoir en entrée le signal périodique de fréquence $f_1$ et à générer au moins deux signaux $S_{G1}$ et $S_{G2}$ en phase l'un avec l'autre et correspondant chacun à un train d'oscillations de fréquence sensiblement égale à $f_a$ et $f_b$ respectivement, de durée inférieure à $T_1 = 1/f_1$ et répété périodiquement à la fréquence $f_1$,
- un additionneur apte à délivrer en sortie le premier signal périodique correspondant à la somme des signaux $S_{G1}$ et $S_{G2}$.

Un tel générateur est également moins coûteux, moins encombrant et consomme moins d'énergie que deux PLL servant à générer deux signaux de fréquences différentes.

Lesdits moyens du générateur peuvent comporter au moins deux oscillateurs commandés en tension dont des plages d'oscillation libre incluent les fréquences $f_a$ et $f_b$ respectivement, et au moins deux interrupteurs reliés à des entrées d'alimentation électrique des oscillateurs commandés en tension et aptes à être commandés par le signal périodique de fréquence $f_1$ tels qu'ils génèrent des tensions d'alimentation des oscillateurs commandés en tension non nulles seulement pendant une partie de chaque période $T_1$ ou au moins deux interrupteurs relié à des sorties des oscillateurs commandés en tension et aptes à être commandés par le signal périodique de fréquence $f_1$ tels qu'ils coupent des liaisons électriques entre les sorties des oscillateurs commandés en tension et des entrées de l'additionneur pendant une partie de chaque période $T_1$. La configuration dans laquelle les interrupteurs sont reliés aux entrées d'alimentation électrique des oscillateurs commandés en tension a pour avantage de ne pas faire fonctionner en permanence les oscillateurs à une fréquence élevée, et donc de réduire la consommation d'énergie des oscillateurs commandés en tension.

Le dispositif peut comporter en outre au moins un deuxième oscillateur verrouillé par injection commutable apte à recevoir en entrée le premier signal périodique et à se verrouiller dans un premier état sur la fréquence $f_b$ et dans un deuxième état sur la fréquence $f_a$, ou à se verrouiller, dans le premier état sur la fréquence $f_a$ et dans le deuxième état sur la fréquence $f_b$, en fonction du signal de commande appliqué en entrée du premier et du deuxième oscillateurs verrouillés par injection commutables. Un tel dispositif peut donc générer en sortie deux signaux à deux fréquences égales ou différentes, et avantageusement de puissances similaires lorsque les raies aux fréquences $f_a$ et $f_b$ du spectre fréquentiel du premier signal périodique ont des amplitudes similaires, et/ou en phase l'un avec l'autre lorsque les raies aux fréquences $f_a$ et $f_b$ du spectre fréquentiel du premier signal périodique sont en phase l'une avec l'autre.

Le spectre fréquentiel du premier signal périodique peut comporter au moins n raies à n fréquences différentes, le dispositif pouvant comporter en outre n oscillateurs verrouillés par injection commutables chacun apte à recevoir en entrée le premier signal périodique et à se verrouiller sur chacune des n fréquences en fonction de la valeur du signal de commande appliqué en entrée des n oscillateurs verrouillés par injection commutables, n étant un nombre entier supérieur à 1.

Le dispositif peut comporter en outre au moins un troisième oscillateur verrouillé par injection commutable apte à recevoir en entrée un signal de sortie du premier ou du deuxième oscillateur verrouillé par injection commutable ou de l'un desdits n oscillateurs verrouillés par injection commutables, et à se verrouiller sur une fréquence similaire à celle sur laquelle est verrouillé l'oscillateur verrouillé par injection commutable (le premier ou le deuxième ou l'un des n oscillateurs verrouillés par injection commutables) auquel est relié le troisième oscillateur verrouillé par injection commutable.

L'invention concerne également un dispositif d'émission et/ou de réception de signaux, comportant au moins un dispositif de génération de signal périodique stable en fréquence tel que décrit précédemment couplé à un modulateur et/ou un démodulateur du dispositif d'émission et/ou de réception. Un tel dispositif peut correspondre à un dispositif émetteur - récepteur RF sans fil intégré, par exemple de type FDD et E-Band.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente schématiquement un dispositif de génération de signal stable en fréquence, objet de la présente invention, selon un premier mode de réalisation ;
- les figures 2 et 3 représentent schématiquement des exemples de réalisation d'un générateur d'un dispositif de génération de signal stable en fréquence, objet de la présente invention ;
- les figures 4A et 4B représentent respectivement la forme d'onde et le spectre d'un signal $S_C$ obtenu dans un générateur d'un dispositif de génération de signal stable en fréquence, objet de la présente invention ;

- les figures 5A et 5B représentent respectivement la forme d'onde et le spectre d'un signal $S_{G1}$ obtenu dans un générateur d'un dispositif de génération de signal stable en fréquence, objet de la présente invention ;
- la figure 6 représente l'addition des spectres fréquentiels des signaux $S_{G1}$ et $S_{G2}$ réalisée dans un générateur d'un dispositif de génération de signal stable en fréquence, objet de la présente invention ;
- la figure 7 représente schématiquement un oscillateur verrouillé par injection commutable d'un dispositif de génération de signal stable en fréquence, objet de la présente invention ;
- la figure 8 représente des plages de verrouillage d'un oscillateur verrouillé par injection commutable d'un dispositif de génération de signal stable en fréquence, objet de la présente invention ;
- la figure 9 représente schématiquement un exemple de réalisation d'un oscillateur verrouillé par injection commutable d'un dispositif de génération de signal stable en fréquence, objet de la présente invention ;
- la figure 10 représente schématiquement un dispositif de génération de signal stable en fréquence, objet de la présente invention, selon un deuxième mode de réalisation ;
- la figure 11 représente schématiquement un dispositif de génération de signal stable en fréquence, objet de la présente invention, selon une première variante du deuxième mode de réalisation ;
- la figure 12 représente schématiquement un dispositif de génération de signal stable en fréquence, objet de la présente invention, selon un troisième mode de réalisation ;
- la figure 13 représente schématiquement un dispositif de génération de signal stable en fréquence, objet de la présente invention, selon une deuxième variante du deuxième mode de réalisation ;
- les figures 14A à 14C représentent des spectres fréquentiels obtenus au sein d'un dispositif de génération de signal stable en fréquence, objet de la présente invention, selon la deuxième variante du deuxième mode de réalisation ;
- la figure 15 représente schématiquement une partie d'un dispositif d'émission - réception, objet de la présente invention ;
- la figure 16 représente schématiquement une partie d'un dispositif d'émission et de réception de signaux, objet de la présente invention, selon un mode de réalisation particulier;
- la figure 17 représente des exemples de répartition de canaux dans une bande de fréquences de transmission utilisée dans le dispositif objet de la présente invention ;
- la figure 18 illustre l'utilisation des symétries pour générer les fréquences utilisées dans le dispositif objet de la présente invention ;
- la figure 19 représente un exemple de réalisation d'un dispositif de synthèse de fréquences faisant partie d'un dispositif d'émission et/ou de réception, objet de la présente invention ;
- les figures 20 et 21 représentent des variantes de réalisation de PLL d'un dispositif de synthèse de fréquences faisant partie d'un dispositif d'émission et/ou de réception, objet de la présente invention ;
- la figure 22 représente une partie d'un dispositif de synthèse de fréquences faisant partie d'un dispositif d'émission et/ou de réception, objet de la présente invention, permettant une transmission de données sur quatre canaux dans chacune des bandes de fréquences de transmission ;
- les figures 23A et 23B représentent des variantes de réalisation de PLL d'un dispositif de synthèse de fréquences faisant partie d'un dispositif d'émission et/ou de réception, objet de la présente invention ;
- la figure 24 représente une variante de réalisation d'une PLL d'un dispositif de synthèse de fréquences faisant partie d'un dispositif d'émission et/ou de réception, objet de la présente invention ;
- la figure 25 représente une partie d'un dispositif de synthèse de fréquences faisant partie d'un dispositif d'émission et/ou de réception, objet de la présente invention, permettant une transmission de données sur quatre canaux de fréquences variables dans chacune des bandes de fréquences de transmission ;
- la figure 26 représente une partie d'un dispositif de synthèse de fréquences faisant partie d'un dispositif d'émission et/ou de réception, objet de la présente invention, permettant une transmission de données sur un canal de fréquence variable dans chacune des bandes de fréquences de transmission ;
- la figure 27 représente schématiquement un exemple de réalisation d'un circuit récupérateur de fréquence permettant de délivrer en sortie des signaux I/Q de même fréquence et utilisé dans un dispositif d'émission et/ou réception, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

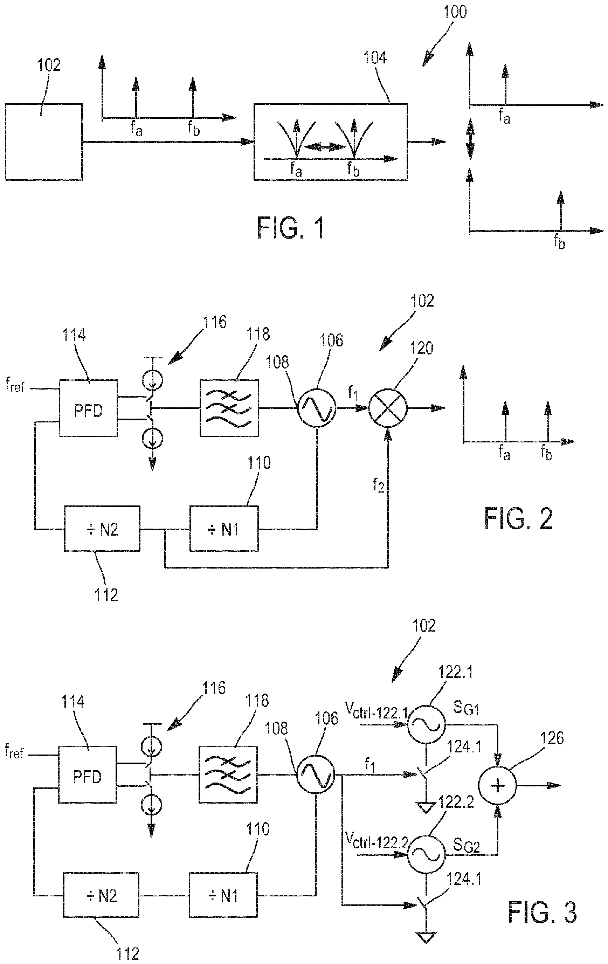

On se réfère tout d'abord à la figure 1 qui représente un dispositif 100 de génération d'un signal périodique stable en fréquence, et dont la fréquence du signal généré peut être modifiée aisément et rapidement, selon un premier mode de réalisation.

Le dispositif 100 comporte un générateur 102 générant un premier signal périodique stable en fréquence dont le spectre fréquentiel comporte deux raies principales à des fréquences différentes, appelées $f_a$ et $f_b$, et dont les valeurs correspondent aux valeurs que peut prendre la fréquence du signal destiné à être généré par le dispositif 100. De manière avantageuse, le générateur 102 est tel que les deux raies principales du spectre fréquentiel du premier signal périodique aient des amplitudes, ou des puissances, similaires ou sensiblement similaires (avec par exemple une différence en tension inférieure ou égale à environ 4 dB). Le dispositif 100 comporte également un oscillateur verrouillé par injection commutable 104, appelé ILO commutable (ILO signifiant « Injection-Locked Oscillator »), recevant en entrée le premier signal périodique.

L'ILO 104 est commutable, c'est-à-dire comporte un mécanisme lui permettant de modifier sa plage de verrouillage, et donc de se verrouiller sur l'une ou l'autre des fréquences $f_a$ et $f_b$ du premier signal périodique selon la configuration dans laquelle se trouve l'ILO commutable 104. Le signal obtenu en sortie de l'ILO commutable 104, correspondant au signal de sortie du dispositif 100, est donc un signal périodique stable en fréquence, par exemple sinusoïdal ou sensiblement sinusoïdal, dont le spectre fréquentiel comporte une seule raie principale à la fréquence $f_a$ ou $f_b$ selon la configuration dans laquelle est mis l'ILO commutable 104.

La figure 2 représente un premier exemple de réalisation du générateur 102.

Le générateur 102 comporte un oscillateur 106, par exemple de type VCO (oscillateur commandé en tension) fournissant en sortie un signal périodique $S_1$ de fréquence $f_1$, par exemple sinusoïdal de fréquence d'oscillation égale à $f_1$. La valeur de la fréquence $f_1$ est contrôlée par une tension appliquée sur une entrée de commande 108 de l'oscillateur 106. Afin de verrouiller et stabiliser la fréquence d'oscillation $f_1$ du signal $S_1$, l'oscillateur 106 est asservi au sein d'une boucle à verrouillage de phase (PLL). Cette PLL comporte un premier diviseur de fréquence 110 apte à diviser la fréquence $f_1$ du signal $S_1$ par un nombre $N_1$ entier ou fractionnaire supérieur à 1. Un signal périodique de fréquence $f_2$ = $f_1/N_1$ est donc obtenu en sortie du premier diviseur de fréquence 110. Ce signal périodique de fréquence $f_2$ est envoyé en entrée d'un deuxième diviseur de fréquence 112 apte à diviser la fréquence $f_2$ par un nombre $N_2$ entier ou fractionnaire supérieur à 1. On obtient ainsi en sortie du deuxième diviseur de fréquence 112 un signal périodique de fréquence $f_1/(N_1.N_2)$ qui est comparé à un autre signal périodique de référence très stable de fréquence $f_{ref}$, par exemple fourni par un résonateur à quartz. Le facteur de division total $(N_1.N_2)$ est choisi tel que la fréquence $f_1/(N_1.N_2)$ soit proche de la fréquence $f_{ref}$ qui est par exemple égale à 25 MHz, le facteur $N_1.N_2$ étant par exemple égal à environ 2400. Une comparaison entre ces deux signaux est réalisée par un comparateur de phases 114 (PFD, ou « Phase Frequency Detector ») générant des signaux de sortie proportionnels à la différence de phases mesurée entre ces deux signaux, dont les valeurs sont positives ou négatives selon le signe de la différence $f_1/(N_1.N_2)$ - $f_{ref}$. Ces signaux de sortie sont envoyés en entrée d'un circuit de pompe de charge 116 puis d'un filtre passe-bas 118 délivrant en sortie le signal appliqué sur l'entrée de commande 108 de l'oscillateur 106 afin d'ajuster la fréquence d'oscillation $f_1$, de sorte à ce que $f_1/(N_1.N_2)$ = $f_{ref}$.

Les signaux périodiques stables en fréquence de fréquence $f_1$ et $f_2$ sont ensuite envoyés sur des entrées d'un mélangeur de fréquences 120 produisant en sortie le premier signal périodique dont le spectre fréquentiel comporte des raies aux fréquences $f_a$ et $f_b$, dont les valeurs correspondent à $f_a$ = $f_1$ - $f_2$ et $f_b$ = $f_1$ + $f_2$.

Lorsque le dispositif 100 est destiné à être utilisé dans un dispositif émetteur - récepteur de type E-Band, la fréquence $f_a$ est par exemple égale à environ 55 GHz et la fréquence $f_b$ égale à environ 65 GHz. Pour obtenir ces fréquences, la PLL du générateur 102 est par exemple réalisée telle que le VCO 106 délivre un signal sinusoïdal $S_1$ de fréquence $f_1$ = 60 GHz. En réalisant le premier diviseur de fréquence 110 tel que $N_1$ = 12, le signal obtenu en sortie du premier diviseur de fréquence 110 correspond à un signal sinusoïdal de fréquence $f_2$ = 5 GHz. Le mélangeur de fréquences 120 génère donc en sortie le premier signal périodique dont le spectre fréquentiel comporte deux raies principales aux fréquences $f_a$ = $f_1$ - $f_2$ = 55 GHz et $f_b$ = $f_1$ + $f_2$ = 65 GHz.

Selon un deuxième exemple de réalisation, le générateur 102 peut correspondre à deux PLL distinctes dont les VCO délivrent en sortie les signaux périodiques de fréquence $f_1$ et $f_2$, et un mélangeur de fréquences similaire au mélangeur de fréquences 120 décrit précédemment et recevant en entrée les signaux de sorties des VCO des deux PLL. Un même signal de référence de fréquence $f_{ref}$ peut être appliqué en entrée des deux PLL afin que les signaux périodiques de fréquence $f_1$ et $f_2$ soient en phase l'un avec l'autre.

La figure 3 représente un troisième exemple de réalisation du générateur 102.

Comme dans le premier exemple de réalisation du générateur 102 précédemment décrit en liaison avec la figure 2, le générateur 102 comporte le VCO 106 asservi par une PLL formée par les éléments 110, 112, 114, 116 et 118. Ces éléments permettent d'obtenir le signal périodique $S_1$, par exemple sinusoïdal, qui est stable en fréquence et de fréquence $f_1$. En variante, il est possible de remplacer le VCO 106 et la PLL par n'importe quel dispositif ou structure apte à fournir un tel signal périodique $S_1$ stable en fréquence, correspondant par exemple à un seul dispositif résonateur lorsqu'un tel dispositif résonateur peut fournir directement le signal $S_1$. Le choix du type de dispositif ou structure générant le signal périodique $S_1$ peut notamment être fait en fonction de la fréquence $f_1$ souhaitée. Un dispositif résonateur seul peut être suffisant si la fréquence $f_1$ ne dépasse pas une valeur au-delà de laquelle il peut alors être nécessaire de faire appel à une PLL pour générer le signal $S_1$, par exemple pour une fréquence $f_1$ inférieure à environ 500 MHz.

Le générateur 102 comporte en outre deux générateurs de train d'oscillations répétées périodiquement (appelé par la suite « TORP ») aux fréquences $f_a$ et $f_b$.

Chaque générateur de TORP comporte un oscillateur 122.1, 122.2 de type VCO contrôlé en tension par un signal de contrôle $V_{ctrl\_122.1}$, $V_{ctrl\_122.2}$, et des moyens d'alimentation électrique commandés 124.1, 124.2 alimentant électriquement l'oscillateur 122.1, 122.2 et qui sont commandés par le signal $S_1$. Sur l'exemple de la figure 3, cette alimentation électrique commandée correspond à une source de courant commandée fonctionnant comme un interrupteur interrompant périodiquement (période $T_1 = 1/f_1$) l'alimentation électrique de l'oscillateur 122.1, 122.2. Cette source de courant commandée peut correspondre à un transistor MOS comportant une grille sur laquelle est appliqué le signal $S_1$. De manière générale, ces moyens d'alimentation électrique commandés 124.1, 124.2 peuvent comporter un interrupteur relié à une entrée d'alimentation électrique de l'oscillateur 122.1, 122.2 et apte à être commandé par le signal périodique $S_1$.

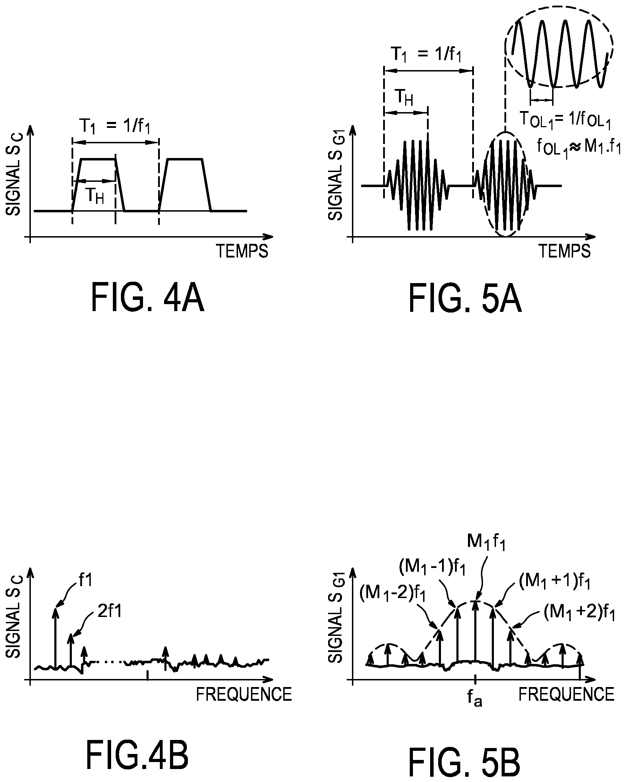

Les oscillateurs 122.1 et 122.2 sont donc commutés par cet interrupteur mettant alternativement les oscillateurs 122.1 et 122.2 en état ON et en état OFF, c'est-à-dire interrompant ou non la fourniture de signaux de sortie par les oscillateurs 122.1 et 122.2, successivement à la fréquence $f_1$. Les oscillateurs 122.1 et 122.2 sont donc commandés par un même signal $S_C$ correspondant aux courants générés par les sources de courant 124.1 et 124.2 (et donc aux tensions d'alimentation fournies aux oscillateurs 122.1 et 122.2) et dont la forme d'onde correspond sensiblement à un signal carré positif de fréquence $f_1$ (ce signal carré n'est pas parfait et peut présenter une forme trapézoïdale, comme c'est le cas du signal $S_C$ représenté par exemple sur la figure 4A).

Ainsi, lorsque le signal de commutation $S_C$ met les oscillateurs 122.1 et 122.2 en marche, des signaux $S_{G1}$ et $S_{G2}$ correspondant à des TORP sont créés aux sorties des oscillateurs 122.1 et 122.2. Une demi-période $T_1/2$ (avec $T_1 = 1/f_1$) plus tard, les oscillateurs 122.1 et 122.2 sont éteints et les oscillations sont interrompues. L'alternance de l'état ON et de l'état OFF toutes les demi-périodes $T_1/2$ correspond au cas où le signal $S_C$ présente un rapport cyclique égal à 0,5. Le signal $S_C$ représenté sur la figure 4A allume les oscillateurs 122.1 et 122.2 pendant une durée $T_H$ qui est égale, dans cet exemple, à $T_1/2$.

Toutefois, ce rapport cyclique (égal à $T_H/T_1$) peut être différent de 0,5, et plus généralement compris entre 0 et 1, les valeurs 0 et 1 étant exclues, la durée de l'état ON pouvant être supérieure ou inférieure à celle de l'état OFF.

Ainsi, des signaux pulsés $S_{G1}$ et $S_{G2}$ sont créés à des fréquences centrales $f_{OL1}$ et $f_{OL2}$, correspondant aux fréquences d'oscillation libre des oscillateurs 122.1 et 122.2, avec une période de répétition égale à $T_1$. Les signaux $S_{G1}$ et $S_{G1}$ correspondent donc à des TORP, c'est-à-dire ici des trains d'oscillations de fréquence $f_{OL1}$ et $f_{OL2}$, de durée inférieure à $T_1 = 1/f_1$ et répété périodiquement avec une période de répétition égale à $T_1$.

Les signaux $S_{G1}$ et $S_{G2}$ ont donc périodiquement une valeur nulle sur une partie de chaque période $T_1$, cette partie de chaque période $T_1$ correspondant approximativement à la partie de chaque période $T_1$ au cours de laquelle le signal $S_C$ a une valeur nulle. Les signaux $S_{G1}$ et $S_{G1}$ ont la particularité d'avoir leur phase verrouillée sur celle du signal $S_1$ de fréquence $f_1$ fourni par l'oscillateur 106 et ont des fréquences centrales $f_{OL1}$ et $f_{OL2}$ qui sont sensiblement égales à des multiples entiers de $f_1$ ($f_{OL1} \approx M_1.f_1$ et $f_{OL2} \approx M_2.f1$). Cette propriété est due au fait qu'au démarrage des oscillations, les oscillateurs 122.1 et 122.2 présentent une élasticité élevée et se verrouillent facilement sur des harmoniques $M_1$ et $M_2$ de la fréquence $f_1$ avec $M_1$ et $M_2$ tels que les produit $M_1.f_1$ et $M_2.f1$ soient les plus proches des fréquences d'oscillation libre $f_{OL1}$ et $f_{OL2}$ des oscillateurs 122.1 et 122.2. Les valeurs de $M_1$ et $M_2$, et donc celles des fréquences $f_{OL1}$ et $f_{OL2}$, dépendent des valeurs des tensions $V_{ctrl\_122.1}$ et $V_{ctrl\_122.2}$ appliquées en entrée des oscillateurs 122.1 et 122.2, ces valeurs des tensions $V_{ctrl\_122.1}$ et $V_{ctrl\_122.2}$ étant choisies telles que $M_1.f_1 = f_a$ et $M_2.f_1 = f_b$.

Le spectre équivalent de chacun des signaux $S_{G1}$ et $S_{G2}$ présente une enveloppe dont la forme correspond à un sinus cardinal dont les composantes sont des sinusoïdes de fréquence centrale $M_1.f_1$ et $M_2.f_1$ respectivement. Les raies des spectres fréquentiels de $S_{G1}$ et $S_{G2}$ sont espacées les unes des autres de $f_1$. Les figures 4A et 4B représentent respectivement la forme d'onde (domaine temporel) et le spectre (domaine fréquentiel) du signal Sc. De même, les figures 5A et 5B représentent respectivement la forme d'onde et le spectre du signal $S_{G1}$. Sur la figure 5A, on voit que dans chaque train d'oscillations du signal $S_{G1}$, les amplitudes des oscillations sont croissantes lors du démarrage de l'oscillateur 114 et sont décroissantes lors de l'arrêt de l'oscillateur 114. De plus, les oscillations des trains d'oscillations de $S_{G1}$ sont similaires, en termes de phase, d'amplitude et de fréquence, d'un train à l'autre. Le spectre fréquentiel du signal $S_{G1}$ comporte donc une raie principale à la fréquence $f_a = M_1.f_1$, et des raies secondaires (d'amplitudes inférieures à celle de la raie principale) aux autres fréquences multiples de $f_1$. La forme d'onde et le spectre fréquentiel du signal $S_{G2}$ sont analogues à ceux du signal $S_{G1}$, avec une raie principale à la fréquence $f_b = M_2.f_1$ et une fréquence d'oscillation libre $f_{OL2} \approx M_2.f_1 = f_b$.

D'un point de vue analytique, le signal $S_{G1}$ est obtenu par la convolution dans le domaine temporel entre un sinus fenêtré, de fréquence $f_{OL1}$ (correspondant à la fréquence d'oscillation libre de l'oscillateur 122.1) et de largeur de fenêtre égale à $T_H$, avec $T_H \in ]0,T_1[$, et un peigne de Dirac de période égale à $T_1$. Le signal $S_{G1}$ peut donc s'exprimer sous la forme :

$$S_{G1}(t) = \left[ sin(2 \cdot \pi \cdot f_{OL1} \cdot t) \cdot \Pi_{T_H}(t) \right] \otimes \sum_{k=-\infty}^{\infty} \delta(t - k \cdot T_1)$$

$\Pi_{T_H}(t)$ est la fonction de fenêtrage correspondant à :

$$\Pi_{T_H}(t) = \begin{cases} 0 & \forall\, t < 0 \\ 1 & \forall\, t \in ]0,T_1[ \\ 0 & \forall\, t > T_H \end{cases}$$

Le spectre fréquentiel du signal $S_{G1}$ correspond dans ce cas à :

$$\left| S_{G1}(f) \right|_{f>0} = \left[ \frac{1}{2} \delta(f - f_{OL1}) \otimes T_H \cdot sinc(\pi \cdot f \cdot T_H) \right] \cdot f_1 \cdot \sum_{k=-\infty}^{\infty} \delta(f - k \cdot f_1)$$

Pour chacune des raies de fréquences $f_j$ du spectre du signal $S_{G1}$ ($f_j$ étant des multiples de $f_1$), l'amplitude $A_j$ de chacune de ces raies peut être exprimée par l'équation :

$$A_j = \frac{1}{2} sin\, c\left( \pi \left( f_j - f_{OL1} \right) T_H \right)$$

Des équations analogues s'appliquent pour le signal $S_{G2}$, le terme $f_{OL1}$ utilisé dans les équations ci-dessus étant alors remplacé par le terme $f_{OL2}$.

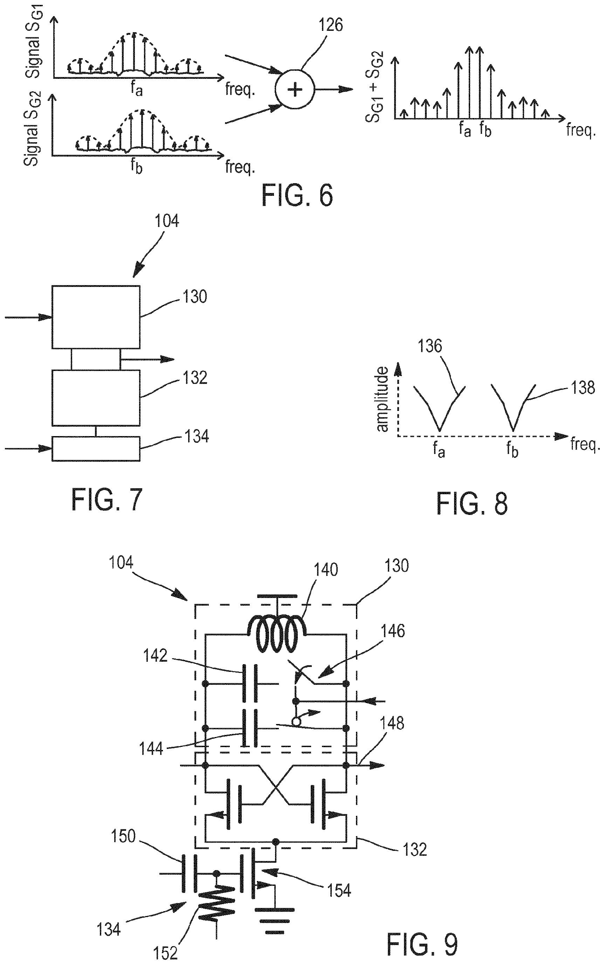

Les signaux $S_{G1}$ et $S_{G2}$ sont ensuite additionnés par un additionneur 126 recevant en entrée les signaux $S_{G1}$ et $S_{G2}$ délivrés par les oscillateurs 122.1 et 122.2. La figure 6 représente symboliquement l'addition des spectres fréquentiels des signaux $S_{G1}$ et $S_{G2}$ réalisée par l'additionneur 126. Le spectre fréquentiel du signal obtenu en sortie de l'additionneur 126 comporte donc deux raies principales aux fréquences $f_a$ et $f_b$ correspondant aux raies principales des spectres fréquentiels des signaux $S_{G1}$ et $S_{G2}$. Sur l'exemple de cette figure, les fréquences $f_a$ et $f_b$ sont des multiples entiers consécutifs de $f_1$ telles que $f_b = f_a + f_1$, et donc avec $M_2 = M_1 + 1$, et les raies aux fréquences $f_a$ et $f_b$ sont de même amplitude. Du fait que les signaux $S_{G1}$ et $S_{G2}$ sont générés à partir du même signal $S_1$, ces signaux ont donc leur phase cohérente l'une par rapport à l'autre

Dans une variante de réalisation du générateur 102 décrit en liaison avec la figure 3, les oscillateurs 122.1 et 122.2 peuvent ne pas être commandés par une source d'alimentation interrompue périodiquement, mais être alimenté en continu, fournissant des signaux sinusoïdaux de fréquences $f_{OL1}$ et $f_{OL2}$. Ces signaux sont alors envoyés en entrée d'interrupteurs commandés par le signal périodique $S_1$. Ces interrupteurs sont donc périodiquement (période $T_1$) en position fermée pendant une durée égale à $T_H$ (par exemple égale à $T_1/2$ dans le cas d'un rapport cyclique de 0,5) et en position ouverte pendant une durée égale à $T_1 - T_H$.

On obtient dans ce cas, en sortie de ces interrupteurs, des signaux $S_{G1}$ et $S_{G2}$ de type TORP, c'est-à-dire de type train d'oscillations de fréquence $f_{OL1}$ ou $f_{OL2}$ répété périodiquement avec une période de répétition égale à $T_1$. Les oscillations de chacun des trains d'oscillations de $S_{G1}$ et $S_{G2}$ ne sont généralement alors pas similaires, en termes de phase, d'un train à l'autre, mais les signaux $S_{G1}$ et $S_{G2}$ sont par contre en phase l'un avec l'autre.

Dans ce cas, d'un point de vue analytique, le signal $S_{G1}$ correspond au produit d'un sinus de fréquence $f_{OL1}$ et d'un signal carré périodique de période $T_1$ et d'une durée à l'état haut $T_H$ avec $T_H \in ]0,T_1[$ tel que :

$$S_{G1}(t) = sin(2 \cdot \pi \cdot f_{OL1} \cdot t) \cdot \left[ \Pi_{T_H}(t) \otimes \sum_{k=-\infty}^{\infty} \delta(t - k \cdot T_1) \right]$$

Le spectre fréquentiel du signal $S_{G1}$ correspond dans ce cas à :

$$\left| S_{G1}(f) \right|_{f>0} = \frac{1}{2} \delta(f - f_{OL1}) \otimes \left[ T_H \cdot sinc(\pi \cdot f \cdot T_H) \cdot f_1 \cdot \sum_{k=-\infty}^{\infty} \delta(f - k \cdot f_1) \right]$$

Des équations analogues s'appliquent pour le signal $S_{G2}$, le terme $f_{OL1}$ utilisé dans les équations ci-dessus étant alors remplacé par le terme $f_{OL2}$.

On se réfère maintenant à la figure 7 qui représente schématiquement l'ILO commutable 104. L'ILO commutable 104 comporte une structure résonante 130, un élément électrique 132 dont l'impédance électrique est équivalente à celle d'une résistance électrique négative (c'est-à-dire aux bornes de laquelle une tension augmente lorsque le courant qui la traverse diminue, et inversement aux bornes de laquelle une tension diminue lorsque le courant qui la traverse augmente), et un circuit d'injection 134 destiné à recevoir en entrée le premier signal périodique sur lequel l'ILO commutable 104 est destiné à se verrouiller.

La structure résonante 130 peut être configurée selon deux états : un premier état tel que la valeur de la fréquence d'oscillation libre de l'ILO commutable 104 soit égale ou proche celle de la fréquence $f_a$, et un deuxième état tel que la valeur de la fréquence s'oscillation libre de l'ILO commutable 104 soit égale ou proche de celle de la fréquence $f_b$. Le passage, ou la commutation, d'un état à l'autre de la structure résonante 130 est réalisé par l'intermédiaire d'un signal de commande appliqué en entrée de la structure résonante 130.

Lorsqu'au signal n'est appliqué à l'entrée du circuit d'injection 134, l'ILO commutable 104 oscille à la fréquence d'oscillation libre dont la valeur dépend de l'état dans lequel se trouve la structure résonante 130. Lorsqu'un signal d'amplitude suffisante et de fréquence proche de la fréquence d'oscillation libre de l'ILO commutable 104 est appliqué à l'entrée du circuit d'injection 134, l'ILO commutable 104 se verrouille alors sur ce signal et la fréquence du signal délivré en sortie par l'ILO commutable 104 ne correspond pas à sa fréquence d'oscillation libre mais est égale à la fréquence du signal appliqué à l'entrée du circuit d'injection 134.

Comme représenté sur la figure 8, la plage de verrouillage de l'ILO commutable 104 a une forme s'approchant d'un « V » dont la pointe, ou extrémité, se trouve à la fréquence d'oscillation libre de l'ILO commutable 104. Sur cette figure 8, une première plage de verrouillage 136 est représentée pour le cas où la structure résonante 130 se trouve dans le premier état (pour laquelle la fréquence d'oscillation libre est proche ou égale à $f_a$), et une deuxième plage de verrouillage 138 est représentée pour le cas où la structure résonante 130 se trouve dans le second état (pour laquelle la fréquence d'oscillation libre est proche ou égale à $f_b$). Ces plages de verrouillage indiquent la valeur de l'amplitude minimum du signal appliqué à l'entrée du circuit d'injection 134, en fonction de la fréquence de ce signal, pour laquelle l'ILO commutable 104 se verrouille et délivre dans ce cas un signal de fréquence égale à celle du signal appliquée à l'entrée du circuit d'injection 134. L'amplitude requise pour verrouiller l'ILO commutable 104 se réduit à mesure que la fréquence du signal appliquée sur l'entrée du circuit d'injection 134 est proche de la fréquence d'oscillation libre de l'ILO 104, et donc proche de $f_a$ lorsque la structure résonante se trouve dans le premier état et proche de $f_b$ lorsque la structure résonante se trouve dans le deuxième état.

La figure 9 représente schématiquement un exemple de réalisation de l'ILO commutable 104. La structure résonante 130 comporte une inductance 140 couplée en parallèle à un premier condensateur 142 et à un deuxième condensateur 144. La valeur de la capacité électrique du premier condensateur 142 est différente de celle du deuxième condensateur 144. La structure résonante 130 comporte également deux interrupteurs 146 fonctionnant de manière complémentaire l'un par rapport à l'autre (l'un des deux interrupteurs étant en position fermée lorsque l'autre des deux interrupteurs est en position ouverte). Les interrupteurs 146 sont commandés par le signal de commande appliqué en entrée de la structure résonante 130. Ainsi, la structure résonante 130 forme un circuit résonant LC qui comporte, dans le premier état, l'inductance 140 et le premier condensateur 142, et dans le deuxième état, l'inductance 140 et le deuxième condensateur 144. Le circuit résonant LC formé par la structure résonante 130 comporte donc le premier condensateur 142 ou le deuxième condensateur 144 selon la valeur du signal de commande appliqué en entrée de la structure résonante 130, et la fréquence d'oscillation libre de l'ILO commutable 104 est donc modifiée selon les éléments formant ce circuit résonant LC.

En variante, la structure résonante 130 peut comporter un unique condensateur couplé à une première inductance dans le premier état et à une deuxième inductance dans le deuxième état, les valeurs de ces deux inductances étant différentes.

Dans une autre variante, il est également possible que la structure résonante 130 comporte une première et une deuxième inductances de valeurs différentes, et un premier et un deuxième condensateurs présentant des capacités de valeurs différentes, la première inductance étant couplée électriquement au premier condensateur dans le premier état, et la deuxième inductance étant couplée électriquement au deuxième condensateur dans le deuxième état.

L'élément électrique 132 correspond à une paire croisée différentielle de type MOS, ici formée par deux transistors NMOS au niveau desquels se trouve une sortie 148 de l'ILO commutable 104.

Le circuit d'injection 134 comporte une capacité 150 de blocage de courant continu couplée à une résistance 152. Le premier signal périodique est destiné à être appliqué sur une première borne de la capacité 150. Une tension de polarisation, définissant le courant de polarisation de l'élément 132, est appliquée sur une première borne de la résistance 152, et une deuxième borne de la résistance 152 est reliée à une deuxième borne de la capacité 150 et à la grille d'un troisième transistor NMOS 154 Le drain du troisième transistor NMOS 154 est relié à l'élément électrique 132.

En variante, le troisième transistor NMOS 154 peut comporter sa source et son drain reliés en parallèle à la structure résonante 130.

Selon une autre variante, le circuit d'injection 134 peut comporter, à la place du troisième transistor NMOS 154, deux transistors MOS dont les drains sont reliés aux drains des deux transistors MOS de l'élément électrique 132 et dont les sources sont reliées à une source de courant de polarisation. Dans cette variante, le circuit d'injection 134 comporte également la capacité 150 couplée à la résistance 152 de manière analogue à la configuration précédemment décrite en liaison avec la figure 9. Le premier signal périodique est destiné à être appliqué sur la première borne de la capacité 150 et une tension de polarisation est destinée à être appliquée sur la première borne de la résistance 152, la deuxième borne de la résistance 152 étant reliée à la deuxième borne de la capacité 150 et aux grilles des deux transistors MOS du circuit d'injection 134 (le premier signal périodique étant dans ce cas une signal différentiel).

Les valeurs de l'inductance 140 et des capacités électriques du premier condensateur 142 et du deuxième condensateur 144 sont choisies telles que la fréquence d'oscillation libre de l'ILO commutable 104 dans le premier état (premier condensateur 142 couplée à l'inductance 140) soit proche ou égale à $f_a$, et telles que la fréquence d'oscillation libre de l'ILO commutable 104 dans un deuxième état (deuxième condensateur 144 couplée à l'inductance 140) soit proche ou égale à $f_b$.

Ainsi, l'ILO commutable 104 qui reçoit en entrée le premier signal périodique comportant deux raies principales aux fréquences $f_a$ et $f_b$ délivre en sortie un signal périodique stable en fréquence et de fréquence $f_a$ ou $f_b$ selon l'état dans lequel se trouve la structure résonante 130. La fréquence du signal de sortie de l'ILO commutable 104 peut être facilement et rapidement commutée entre $f_a$ et $f_b$ en changeant l'état dans lequel se trouve la structure résonante 130. L'ILO commutable 104 se comporte comme un filtre passe-bande très sélectif par le biais du verrouillage réalisé sur la fréquence $f_a$ ou $f_b$.

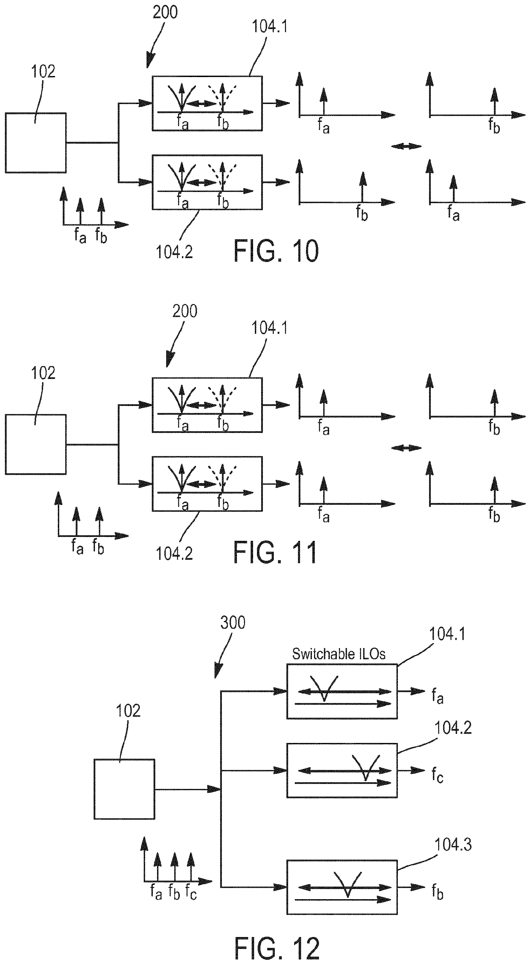

La figure 10 représente un dispositif 200 de génération de deux signaux stables en fréquence et dont les valeurs des fréquences peuvent être modifiées, selon un deuxième mode de réalisation.

Comme pour le dispositif 100 précédemment décrit, le dispositif 200 comporte le générateur 102 générant le premier signal périodique stable en fréquence dont le spectre fréquentiel comporte deux raies principales aux fréquences $f_a$ et $f_b$. Ce premier signal périodique est envoyé sur les entrées de deux ILO commutables 104.1 et 104.2, par exemple similaires à l'ILO commutable 104 précédemment décrit. Les ILO commutables 104.1 et 104.2 sont commandés tels qu'ils puissent se trouver dans deux configurations :

- dans une première configuration, le premier ILO commutable 104.1 se verrouille sur la fréquence $f_a$ et délivre alors en sortie un signal périodique stable en fréquence et dont le spectre fréquentiel comporte une seule raie principale centrée sur $f_a$, et le deuxième ILO commutable 104.2 se verrouille sur la fréquence $f_b$ et délivre alors en sortie un autre signal périodique stable en fréquence et dont le spectre fréquentiel comporte une seule raie principale centrée sur $f_b$ ;
- dans une deuxième configuration, le premier ILO commutable 104.1 se verrouille sur la fréquence $f_b$ et délivre alors en sortie un signal périodique stable en fréquence et dont le spectre fréquentiel comporte une seule raie principale centrée sur $f_b$, et le deuxième ILO commutable 104.2 se verrouille sur la fréquence $f_a$ et délivre alors en sortie un autre signal périodique stable en fréquence et dont le spectre fréquentiel comporte une seule raie principale centrée sur $f_a$.

Ainsi, quelque soit la configuration des ILO commutables 104.1 et 104.2, les fréquences au niveau desquelles se trouvent les raies principales des spectres fréquentiels des signaux obtenus en sortie des ILO commutables 104.1 et 104.2 sont toujours différentes l'une par rapport à l'autre, l'une étant égale à $f_a$ et l'autre étant égale à $f_b$. Un tel dispositif 200 est donc bien adapté pour être utilisé dans un dispositif émetteur - récepteur réalisant simultanément une émission et une réception de signaux dans deux bandes de fréquences distinctes et pouvant être permutées.

Dans une variante de réalisation du dispositif 200 représentée sur la figure 11, les configurations selon lesquelles les ILO commutables 104.1 et 104.2 sont commandés peuvent être telles que :

- dans une première configuration, le premier ILO commutable 104.1 et le deuxième ILO commutable 104.2 se verrouillent sur la fréquence $f_a$ et délivrent alors en sortie des signaux périodiques stables en fréquence et dont les spectres fréquentiels comportent une seule raie principale centrée sur $f_a$ ;
- dans une deuxième configuration, le premier commutable ILO 104.1 et le deuxième ILO commutable 104.2 se verrouillent sur la fréquence $f_b$ et délivrent alors en sortie des signaux périodiques stables en fréquence et dont les spectres fréquentiels comportent une seule raie principale centrée sur $f_b$.

Dans les dispositifs 100 et 200 précédemment décrits, le spectre fréquentiel du premier signal périodique généré par le générateur 102 comporte deux raies principales aux fréquences $f_a$ et $f_b$, et le ou les ILO commutables permettent de générer en sortie des signaux périodiques stables de fréquence et de fréquence correspondant à l'une des deux fréquences $f_a$ et $f_b$ auxquelles se trouvent ces raies principales. En variante, le spectre fréquentiel du premier signal périodique généré par le générateur 102 peut comporter n raies principales localisées au niveau de n fréquences distinctes, le générateur 102 faisant dans ce cas par exemple appel à plusieurs PLL ou oscillateurs et mélangeurs de fréquences. Dans ce cas, le dispositif peut comporter un nombre plus important d'ILO commutables chacun apte à se verrouiller sur au moins deux desdites n fréquences selon l'état dans lequel se trouve l'ILO commutable, pour délivrer un nombre plus important de signaux de sortie stables en fréquence, et/ou dont le ou les ILO sont aptes à se verrouiller sur plus de deux fréquences afin d'obtenir en sortie un ou plusieurs signaux périodiques stables dont la fréquence peut prendre plus de deux valeurs.

La figure 12 représente un dispositif 300 dans lequel le signal délivré par le générateur 102 comporte trois raies principales aux fréquences $f_a$, $f_b$ et $f_c$, et trois ILO commutables 104.1, 104.2 et 104.3 chacun apte à se verrouiller sur l'une des trois fréquences $f_a$, $f_b$ et $f_c$ (par exemple via l'utilisation de trois capacités de valeurs différentes dans les structures résonantes de ces ILO commutables). Les fréquences obtenues sur les trois sorties des ILO commutables 104.1, 104.2 et 104.3 peuvent être différentes les unes des autres (un signal de chacune des trois fréquences $f_a$, $f_b$ et $f_c$ sur les trois sorties) ou bien au moins en partie similaires (par exemple un des signaux de sortie à l'une des trois fréquences $f_a$, $f_b$ et $f_c$ et les deux autres signaux de sortie à l'une des deux autres fréquences, ou bien les trois signaux de sortie à la même fréquence $f_a$, $f_b$ ou $f_c$).

Dans chacun des dispositifs 100, 200 et 300, les sorties des ILO commutables 104 peuvent être reliées en série à un ou plusieurs autres ILO commutables afin d'améliorer la pureté spectrale des signaux obtenus en sortie de ces dispositifs. En effet, le signal de sortie d'un tel ILO commutable est composé principalement de la raie sur laquelle l'ILO commutable est verrouillé, mais la réjection des raies adjacentes à la raie principale n'est pas infinie. Le signal obtenu en sortie de l'ILO commutable 104 peut correspondre non pas à un signal sinusoïdal pur, mais à un signal périodique dont l'enveloppe n'est jamais nulle et dont le spectre fréquentiel présente une raie principale à la fréquence à laquelle l'ILO commutable est verrouillé. Les raies secondaires de ce spectre fréquentiel, se trouvant à des fréquences multiples de $f_1$, ont des amplitudes inférieures à celle de la raie principale de ce spectre fréquentiel. L'ajout d'un ou plusieurs ILO commutables en série permet d'atténuer ou supprimer ces raies secondaires.

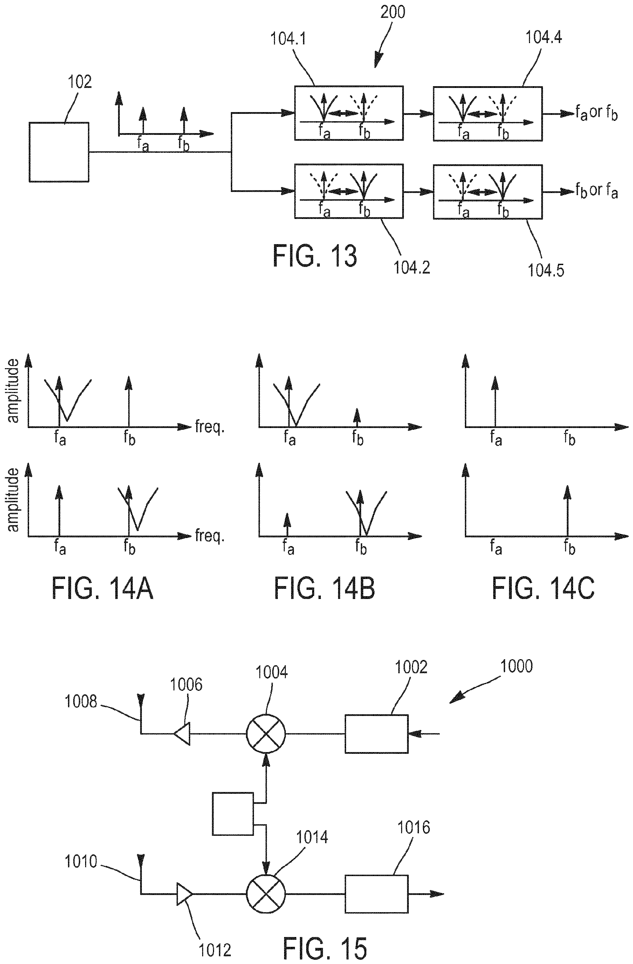

La figure 13 représente une autre variante du dispositif 200 précédemment décrit en liaison avec la figure 10. Dans ce dispositif 200, chacun des ILO commutables 104.1 et 104.2 est relié en série à un autre ILO commutable 104.4 et 104.5 par exemple similaire à l'ILO commutable auquel il est relié. L'ILO commutable 104.4 est configuré dans le même état de verrouillage que celui de l'ILO commutable 104.1 (par exemple sur la fréquence $f_a$) et l'ILO commutable 104.5 est configuré dans le même état de verrouillage que celui de l'ILO commutable 104.2 (par exemple à la fréquence $f_b$). La figure 14A représente les spectres des signaux appliqués en entrée des ILO commutables 104.1 et 104.2, et comportent deux raies principales aux fréquences $f_a$ et $f_b$. Les plages de verrouillage des ILOS commutables 104.1 et 104.2 sont également représentées symboliquement sur cette figure. La figure 14B représente les spectres des signaux obtenus en sortie des ILO commutables 104.1 et 104.2 et appliqués en entrées des ILO commutables 104.4 et 104.5. On voit sur cette figure 14B que des raies de faibles amplitudes sont encore présentes aux fréquences sur lesquelles les ILO commutables 104.1 et 104.2 n'étaient pas verrouillés. Les plages de verrouillage des ILO commutables 104.4 et 104.5 sont également représentées symboliquement sur cette figure 14B. Enfin, la figure 14C représente les spectres des signaux obtenus en sorties des ILO commutables 104.4 et 104.5. On voit sur cette figure 14C que les raies de faibles amplitudes qui étaient encore présentes aux fréquences sur lesquelles les ILO commutables 104.1 et 104.2 n'étaient pas verrouillés (figure 14B) ont disparues et cela grâce au « filtrage » plus fin réalisé via les ILO commutables 104.4 et 104.5.

La figure 15 représente schématiquement une partie d'un dispositif émetteur- récepteur 1000 de type FDD adapté au standard de communication E-Band et fonctionnant simultanément en émission et en réception dans deux bandes de fréquences différentes de largeur égale à environ 5 GHz et centrées autour des fréquences 70 GHz et 80 GHz. Le dispositif 1000 comporte des éléments servant à réaliser une émission de signaux tels qu'un circuit de traitement en bande de base 1002 recevant en entrée l'information à émettre, un modulateur 1004, un amplificateur de puissance 1006 et une antenne d'émission 1008. Le dispositif 200 est par exemple utilisé avec le modulateur 1004 afin de moduler le signal à la fréquence porteuse souhaitée (autour de la fréquence $f_a$ par exemple). Le système de transmission 1000 comporte également des éléments servant à réaliser une réception de signaux : une antenne de réception 1010, un amplificateur faible bruit 1012, un démodulateur 1014 et un circuit de traitement en bande de base 1016. Le dispositif 200 est utilisé également avec le démodulateur 1014 afin de démoduler le signal reçu (autour de la fréquence $f_b$ par exemple) en bande de base. Les bandes de fréquences d'émission et de réception peuvent être facilement commutées changeant l'état dans lequel est configuré le dispositif 200.

Le dispositif de génération de signaux stables en fréquence précédemment décrit peut également être utilisé au sein de tout type de dispositif émetteur - récepteur faisant appel à plusieurs signaux stables en fréquence et de fréquences différentes et qui requièrent de modifier rapidement ces fréquences, comme par exemple des dispositifs émetteurs - récepteurs multi-standards.

Le dispositif de génération de signaux stables en fréquence précédemment décrit peut également être utilisé au sein d'un dispositif émetteur - récepteur électro-optique apte à envoyer des données via un multiplexage en longueurs d'ondes (WDM), c'est-à-dire en modulant plusieurs longueurs d'ondes envoyées via un même guide d'onde optique. Le dispositif de génération de signaux stables en fréquence précédemment décrit peut dans ce cas être utilisé pour extraire chaque longueur d'onde du signal comportant les différentes longueurs d'ondes multiplexées et router ces différents signaux de longueurs d'ondes différentes vers différentes sorties. Le dispositif de génération de signaux stables en fréquence permet dans ce cas de modifier aisément et rapidement les chemins sur lesquels sont routés les différents signaux de différentes longueurs d'ondes.

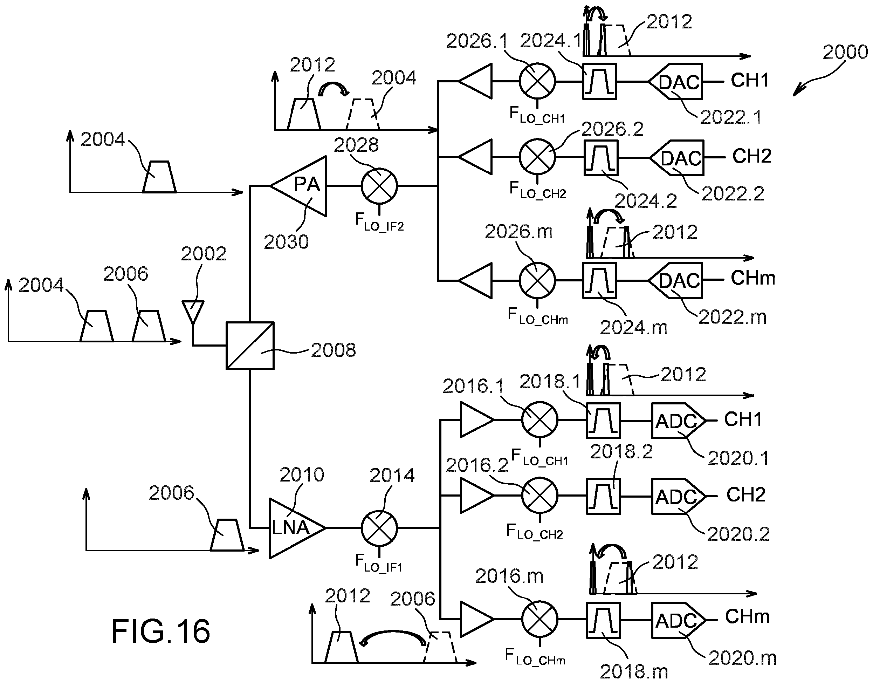

L'utilisation d'un oscillateur verrouillé par injection commutable pour générer un signal stable en fréquence est également avantageuse dans un dispositif 2000 d'émission et de réception apte à réaliser une émission et une réception de signaux dans deux bandes de fréquences de transmission RF, par exemple de type E-band (transmission dans les bandes 71 - 76 GHz et 81 - 86 GHz), et réalisant des transpositions de fréquences en utilisant m canaux permettant une division de chacune de ces bandes RF en m sous-bandes fréquentielles, m étant un nombre entier supérieur à 1, tel que représenté schématiquement sur la figure 16.

Le dispositif 2000 comporte une antenne 2002 servant à l'émission et à la réception des données. Dans l'exemple décrit ici, les fréquences de la bande de fréquences de transmission utilisée pour l'émission de données, représentée symboliquement avec la référence 2004, sont inférieures à celles de la bande de fréquences de transmission utilisée pour la réception de données, représentée symboliquement avec la référence 2006. La bande basse de fréquences 2004 utilisée pour l'émission de données correspond par exemple à la bande 71 - 76 GHz, et la bande haute de fréquences 2006 utilisée pour la réception de données correspond par exemple à la bande 81 - 86 GHz. En variante, la bande basse de fréquences 2004 pourrait être utilisée pour la réception de données et la bande haute de fréquences 2006 pour l'émission de données. Le dispositif 2000 comporte également un élément 2008 permettant à l'antenne 2002 de fonctionner conjointement avec les éléments d'émission et les éléments de réception du dispositif 2000.

Lorsqu'un signal est reçu par l'antenne 2002, celui-ci est envoyé, via l'élément 2008, en entrée d'un amplificateur faible bruit (LNA) 2010, puis transposé dans une bande de fréquences intermédiaires 2012 par un mélangeur 2014 recevant en entrée le signal reçu et un signal périodique stable de fréquence $F_{LO\_IF1}$, appelé $S_{LO\_IF1}$.

La largeur de la bande haute de fréquences 2006 correspond à celle de la bande de fréquences intermédiaires 2012. Plusieurs convertisseurs analogique - numérique sont utilisés pour convertir les signaux se trouvant dans les différents canaux de cette bande de fréquences. Cette large bande de fréquences 2012 est démultiplexée en fréquence afin d'obtenir m sous-bandes de fréquences moins larges réparties sur m canaux comprenant chacun un convertisseur analogique - numérique, permettant de retrouver les signaux transmis dans les différents canaux de la bande 2006.

Ce démultiplexage est réalisé sur les m canaux via une seconde transposition de fréquences de m parties de la bande de fréquences intermédiaires 2012 vers m bandes de fréquences intermédiaires plus basses, ou directement en bande de base (directement en bande de base sur l'exemple représenté sur la figure 16). Sur la figure 16 ce démultiplexage, ou seconde transposition de fréquences, est réalisé via m mélangeurs 2016.1 - 2016.m recevant chacun en entrée le signal dans la bande de fréquences intermédiaires 2012 et un signal périodique stable de fréquence centrale adaptée à la partie de la bande de fréquences intermédiaires 2012 destinée à être récupérée et transposée en bande de base. Chacun des mélangeurs 2016.1 - 2016.m reçoit donc en entrée, en plus du signal de fréquences intermédiaires, un signal périodique stable de fréquence différente pour chaque canal, ici de fréquences $F_{LO\_CH1}$ à $F_{LO\_CHm}$, ces signaux étant appelés $S_{LO\_CH1}$ à $S_{LO\_CHm}$. Les signaux en bande de base obtenus en sortie des mélangeurs 2016.1 - 2016.m sont ensuite filtrés individuellement par des filtres passe-bande 2018.1 - 2018.m, puis convertis numériquement par des convertisseurs analogiques - numériques 2020.1 - 2020.m, et délivrés sur les canaux CH1 à CHm.

Pour réaliser une émission de signaux, les opérations inverses à celles réalisées lors de la réception précédemment décrite sont mises en oeuvre. Ainsi, les signaux en bande de base des canaux CH1 à CHm sont tout d'abord convertis individuellement par des convertisseurs numériques - analogiques 2022.1 - 2022.m, puis filtrés individuellement par des filtres passe-bande 2024.1 - 2024.m, et transposés dans la bande de fréquences intermédiaires 2012 via un multiplexage dans le domaine fréquentiel réalisé par des mélangeurs 2026.1 - 2026.m recevant chacun en entrée un des signaux analogiques filtrés et un des signaux $S_{LO\_CH1}$ à $S_{LO\_CHm}$. Les signaux se trouvant dans la bande de fréquences intermédiaires 2012 ainsi combinés forment un seul signal réparti sur la bande de fréquences intermédiaires 2012. Une transposition dans la bande de fréquences 2004 est ensuite réalisée par un mélangeur 2028 recevant en entrée le signal dans la bande de fréquences intermédiaires 2012 ainsi qu'un signal de fréquence $F_{LO\_IF2}$, appelé $S_{LO\_IF2}$. Le signal de sortie du mélangeur 2028 est enfin amplifié par un amplificateur de puissance 2030 puis émis par l'antenne 2002.

Les différents canaux CH1 à CHm fonctionnent simultanément ou non lors d'une émission ou d'une réception de données.

Dans un dispositif d'émission - réception de type FDD, les bandes de fréquences intermédiaires utilisées à l'émission et à la réception sont similaires.

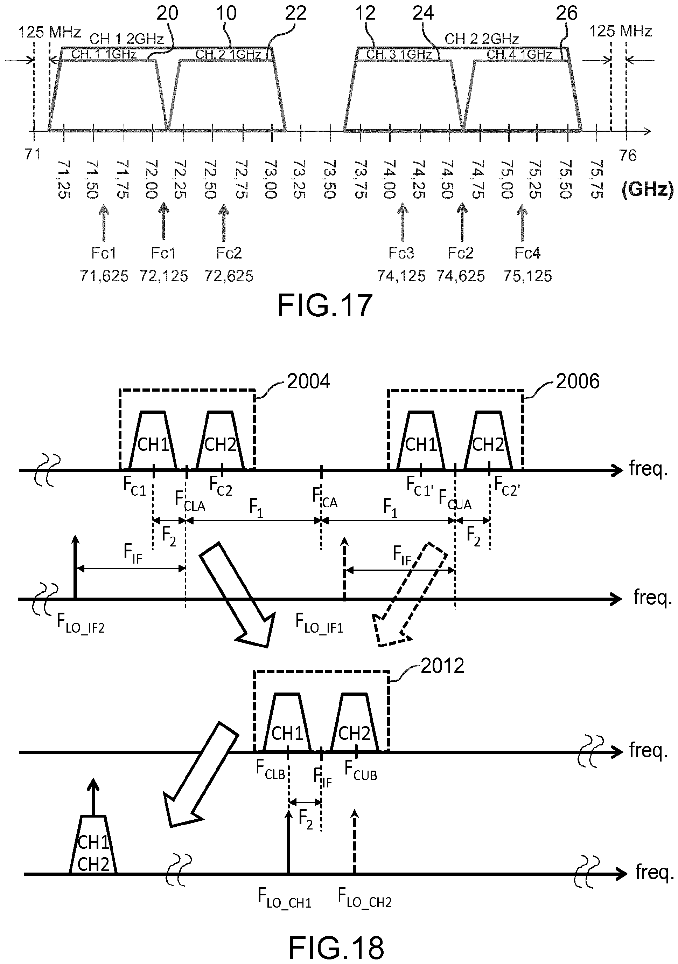

La figure 17 représente deux exemples de répartition des canaux dans la bande basse de fréquences de transmission 71 - 76 GHz.

On voit sur cette figure un premier exemple dans lequel deux canaux CH1 et CH2 référencés 10 et 12, chacun de largeur égale à 2 GHz, sont utilisés dans la bande 71 - 76 GHz. Par analogie avec la figure 16, ce premier exemple correspond à une configuration du dispositif 2000 dans laquelle m = 2. Dans ce cas, le premier canal 10 a une fréquence centrale $F_{c1}$ = 72,125 GHz, et le deuxième canal 12 a une fréquence centrale $F_{c2}$ = 74,625 GHz. Un deuxième exemple est également représenté dans lequel quatre canaux CH1 à CH4 référencés 20, 22, 24 et 26, chacun de largeur égale à 1 GHz, sont utilisés (cas de la figure 16 dans lequel m = 4). Dans ce cas, le premier canal 20 a une fréquence centrale $F_{c1}$ = 71,625 GHz, le deuxième canal 22 a une fréquence centrale $F_{c2}$ = 72,625 GHz, le troisième canal 24 a une fréquence centrale $F_{c3}$ = 74,125 GHz, et le quatrième canal 26 a une fréquence centrale $F_{c4}$ = 75,125 GHz. On voit également sur cette figure que dans tous les cas, des bandes de garde de 125 MHz sont présentes aux extrémités de la bande basse de fréquences de transmission. Une configuration similaire des canaux se retrouve dans la bande haute de fréquences de transmission 81 - 86 GHz.

La génération des signaux $S_{LO\_CH1}$ à $S_{LO\_CHm}$ et des signaux $S_{LO\_IF1}$ et $S_{LO-IF2}$ est réalisée en utilisant les symétries qui existent entre les fréquences centrales des différents canaux et entre les bandes de fréquences de transmission 2004 et 2006. Ainsi, dans les deux exemples représentés sur la figure 17, on voit que la répartition des canaux dans la bande 71 - 76 GHz est symétrique autour de la fréquence 73,375 GHz, appelée $F_{CLA}$ (idem dans la bande 81 - 86 GHZ autour de la fréquence 83,375 GHz, appelée $F_{CUA}$). De plus, les deux bandes haute et basse de fréquences de transmission ont chacune une fréquence centrale (73,5 GHz pour la bande 71 - 76 GHz et 83,5 GHz pour la bande 81 - 86 GHz) éloignée de manière égale d'une fréquence de symétrie appelée $F_{CA}$, qui est égale à 78,5 GHz pour les bandes 71 - 76 GHz et 81 - 86 GHz.

La figure 18 illustre le principe utilisé pour générer les signaux $S_{LO\_CH1}$ à $S_{LO\_CHm}$ et des signaux $S_{LO\_IF1}$ et $S_{LO\_IF2}$ en fonction des répartitions des canaux dans les bandes de fréquences hautes et basses d'émission - réception.

Dans l'exemple de la figure 18, deux canaux CH1 et CH2 de largeur égale à 2GHz sont présents dans la bande basse de fréquences de transmission 2004 (par exemple la bande 71 - 76 GHz) et sont disposés symétriquement dans cette bande de part et d'autre de la fréquence $F_{CLA}$. Cette configuration correspond aux canaux 10 et 12 précédemment décrits en liaison avec la figure 17. La distance entre chacune des fréquences centrales $F_{c1}$ et $F_{c2}$ des canaux CH1 et CH2 et la fréquence $F_{CLA}$ est appelée $F_2$. De même, deux canaux CH1 et CH2 de même largeur sont présents dans la bande haute de fréquences de transmission 2006 (par exemple la bande 81 - 86 GHz) et sont disposés symétriquement dans cette bande de part et d'autre de la fréquence $F_{CUA}$. La distance entre les fréquences centrales $F_{c1'}$ et $F_{c2'}$ de ces canaux et la fréquence $F_{CUA}$ correspond également à $F_2$. Les deux fréquences $F_{CLA}$ et $F_{CUA}$ sont à distance égale de la fréquence de symétrie des bandes appelée $F_{CA}$, cette distance étant appelée $F_1$.

La fréquence $F_{LO\_IF2}$ correspond à la fréquence permettant de réaliser la transposition entre la bande de fréquences intermédiaires 2012 et la bande basse de fréquences de transmission 2004. La fréquence $F_{LO\_IF1}$ correspond à la fréquence permettant de réaliser la transposition de la bande haute de fréquences de transmission 2006 dans la bande de fréquences intermédiaires 2012. La distance entre la fréquence $F_{LO\_IF2}$ et la fréquence $F_{CLA}$, appelée $F_{IF}$, est égale à celle entre la fréquence $F_{LO\_IF1}$ et la fréquence $F_{CUA}$.

Les canaux qui sont transposés dans la bande de fréquences intermédiaires 2012 présentent une symétrie autour de la fréquence $F_{IF}$. Sur l'exemple de la figure 18, les canaux CH1 issus des bandes haute et basse de fréquences de transmission 2004 et 2006 ont tous les deux, après transposition dans la bande de fréquences intermédiaires 2012, une même fréquence centrale $F_{CLB}$ et les canaux CH2 ont tous les deux une même fréquence centrale $F_{CUB}$. La distance entre $F_{IF}$ et l'une de ces deux fréquences centrales est la même que la distance $F_2$ identifiée précédemment.

Le passage entre la bande de fréquences intermédiaires 2012 et la bande de base pour les canaux est réalisé à partir des fréquences $F_{LO\_CH1}$ et $F_{LO\_CH2}$. Ces deux fréquences sont symétriques par rapport à la fréquence $F_{IF}$.

Des symétries analogues sont présentes en considérant que chacun des canaux CH1 et CH2 décrits en liaison avec la figure 18 correspond à un groupe d'au moins deux canaux.

Le dispositif 2000 comporte donc un dispositif de synthèse de fréquences permettant de générer simultanément les signaux périodiques stables en fréquence $S_{LO\_IF1}$, $S_{LO\_IF2}$, et $S_{LO\_CH1}$ à $S_{LO\_CHm}$ dans l'exemple précédemment décrit, et cela avec un minimum d'éléments grâce aux symétries identifiées. Ce dispositif de synthèse de fréquences génère ces signaux en combinant deux composantes fréquentielles, l'une permettant d'obtenir le centre de symétrie et l'autre correspondant à l'espacement entre ce centre et les fréquences désirées. Pour cela, le dispositif de synthèse de fréquences comporte deux parties, basées chacune sur une PLL, l'une permettant de générer les signaux de fréquences $F_{LO\_IF1}$ et $F_{LO\_IF2}$, et l'autre permettant de générer les signaux de fréquences $F_{LO\_CH1}$ à $F_{LO\_CHm}$.

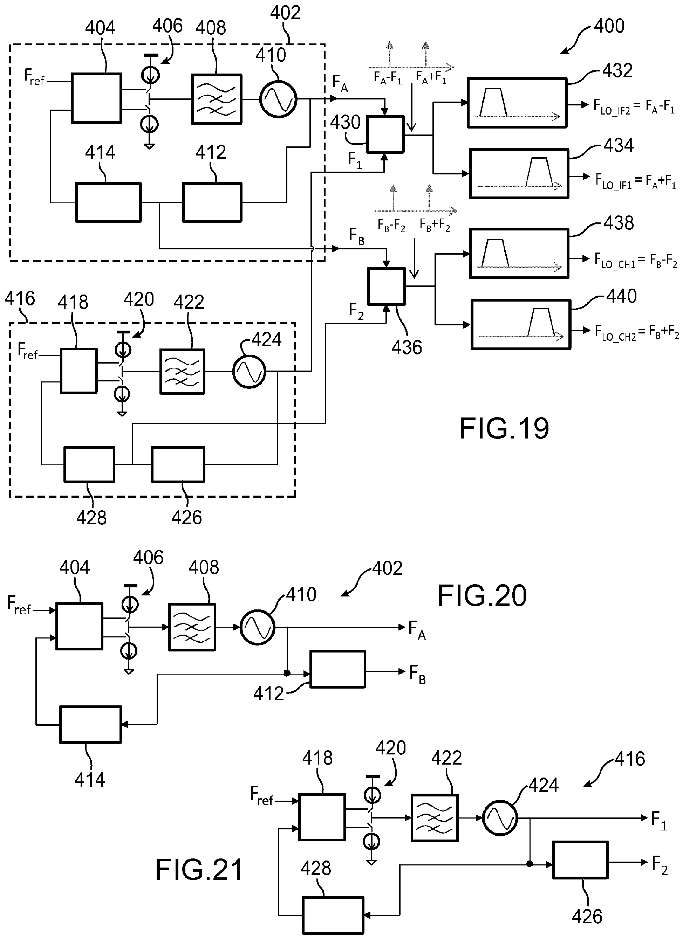

La figure 19 représente un tel dispositif de synthèse de fréquences 400 selon un premier mode de réalisation.

Le dispositif 400 comporte une première PLL 402. Un signal périodique de référence très stable en fréquence, par exemple issu d'un résonateur à quartz, de fréquence $F_{ref}$, est appliqué sur une première entrée d'un comparateur de phases 404 (PFD pour «Phase Frequency Detector »). Les signaux de sortie du comparateur de phases 404 sont envoyés en entrée d'un circuit de pompe de charge 406 puis d'un filtre passe-haut 408. Le filtre 408 délivre en sortie un signal appliqué sur l'entrée d'un oscillateur 410, ici un VCO (oscillateur commandé en tension), par exemple réalisé sous la forme de paires croisées différentielles (résonateur couplé avec une résistance négative) délivrant en sortie un signal sinusoïdal de fréquence $F_A$. Ce signal de fréquence $F_A$ est utilisé pour la génération des signaux de fréquence $F_{LO\_IF1}$ et $F_{LO\_IF2}$. Ce signal est appliqué en entrée d'un premier diviseur de fréquence 412 réalisant une division de fréquence de facteur N1 correspondant à un nombre supérieur à 1, et avantageusement un nombre entier supérieur à 1. Ce premier diviseur de fréquence 412 délivre en sortie un signal de fréquence $F_B = F_A/N1$ utilisé pour la génération des signaux de fréquence $F_{LO\_CH1}$ à $F_{LO\_CHm}$ ($F_{LO\_CH1}$ et $F_{LO\_CH2}$ sur l'exemple de la figure 19). Ce signal est en outre appliqué en entrée d'un deuxième diviseur de fréquence 414 réalisant une division de fréquence de facteur N2 qui correspond à un nombre supérieur à 1, et avantageusement un nombre entier supérieur à 1, et dont la sortie est reliée sur une deuxième entrée du comparateur de phases 404. Le facteur N2 est tel que $F_{ref} = F_B/N2 = F_A/(N1.N2)$.

Le dispositif 400 comporte une deuxième PLL 416. Le signal de référence de fréquence $F_{ref}$ est appliqué sur une première entrée d'un deuxième comparateur de phases 418. Les signaux de sortie du deuxième comparateur de phases 418 sont envoyés en entrée d'un deuxième circuit de pompe de charge 420 et d'un deuxième filtre passe-haut 422. Le deuxième filtre 422 délivre en sortie un signal appliqué sur l'entrée d'un deuxième oscillateur 424, ici un VCO, délivrant en sortie un signal de fréquence $F_1$. Ce signal de fréquence $F_1$ est utilisé pour la génération des signaux de fréquence $F_{LO\_IF1}$ et $F_{LO\_IF2}$. Ce signal est appliqué en entrée d'un troisième diviseur de fréquence 426 réalisant une division de fréquence de facteur N3 qui correspond à un nombre supérieur à 1, et avantageusement un nombre entier supérieur à 1. Ce troisième diviseur de fréquence 426 délivre en sortie un signal de fréquence $F_2 = F_1/N3$ utilisé pour la génération des signaux de fréquence $F_{LO\_CH1}$ et $F_{LO\_CH2}$. Ce signal est en outre appliqué en entrée d'un quatrième diviseur de fréquence 428 réalisant une division de fréquence de facteur N4 qui correspond à un nombre supérieur à 1, et avantageusement un nombre entier supérieur à 1, et dont la sortie est reliée sur une deuxième entrée du deuxième comparateur de phases 418. Le facteur N4 est tel que $F_{ref} = F_2/N4 = F_1/(N3.N4)$.

Les oscillateurs 410 et 424 peuvent être réalisés comme décrit dans les documents « A 60 GHz UWB impulse radio transmitter with integrated antenna in CMOS65nm SOI technology » de A. Siligaris et al., Silicon Monolithic Integrated Circuits in RF Systems (SiRF), 2011 IEEE 11th Topical Meeting on, pp. 153-156, 17-19 Jan. 2011 et « A 17.5-to-20.94GHz and 35-to-41.88GHz PLL in 65nm CMOS for wireless HD applications » de O. Richard et al., Solid-State Circuits Conférence Digest of Technical Papers (ISSCC), 2010 IEEE International, pp.252-253, 7-11 Feb. 2010.

Les diviseurs de fréquence 412, 414, 426 et 428 peuvent utiliser différentes architectures selon la valeur de la fréquence divisée. Aux fréquences élevées, les diviseurs de fréquence tels que les diviseurs 412 et 414 utilisent des circuits de type CML (« Current Mode Logic ») ou ILFD (« Injection Locked Frequency Divider »). Les diviseurs de fréquence fonctionnant à plus basses fréquences, par exemple proches de 1 GHz, tels que les diviseurs 426 et 428 utilisent des architectures purement numériques de type compteur. Si les diviseurs 426 et 428 fonctionnent à des fréquences plus élevées, ces diviseurs comportent par exemple un premier étage de division de type CML qui réduit la fréquence à diviser, délivrant par exemple en sortie un fréquence de l'ordre d'1 GHz, puis un second étage formant des diviseurs purement numériques. Les circuits formant les diviseurs de fréquence peuvent être programmables afin que les valeurs des facteurs de division soient ajustables, selon les valeurs des fréquences $F_A$, $F_B$, $F_1$ et $F_2$ recherchées.

Les signaux de fréquences $F_A$ et $F_1$ sont appliqués en entrée d'un premier élément 430 réalisant une opération non linéaire entre ces signaux et générant un premier signal multi-tonalités, ou multifréquences, à partir de ces signaux. Ce premier élément 430 correspond par exemple à un mélangeur réalisant une multiplication des signaux d'entrée de fréquences $F_A$ et $F_1$. Le premier signal multi-tonalités obtenu en sortie du premier élément 430 comporte donc, dans son spectre fréquentiel, une première raie principale à la fréquence $F_A-F_1$ qui correspond à la fréquence $F_{LO\_IF2}$, et une deuxième raie principale à la fréquence $F_A+F_1$ qui correspond à la fréquence $F_{LO\_IF1}$. Ce premier signal multi-tonalités est envoyé à l'entrée d'un premier circuit récupérateur de fréquence 432 rejetant les fréquences autres que la fréquence $F_{LO\_IF2}$ et délivrant en sortie le signal périodique de fréquence $F_{LO\_IF2}$, et à l'entrée d'un deuxième circuit de récupération de fréquence 434 rejetant les fréquences autres que la fréquence $F_{LO\_IF1}$ et délivrant en sortie le signal périodique de fréquence $F_{LO\_IF1}$.

Les signaux de fréquences $F_B$ et $F_2$ sont appliqués en entrée d'un deuxième élément 436 réalisant une opération non linéaire entre ces signaux et générant un deuxième signal multi-tonalités à partir de ces signaux. Ce deuxième élément 436 correspond par exemple à un mélangeur réalisant une multiplication des signaux d'entrée de fréquences $F_B$ et $F_2$. Le deuxième signal multi-tonalités obtenu en sortie du deuxième élément 436 comporte donc, dans son spectre fréquentiel, une première raie principale à la fréquence $F_B$-$F_2$ qui correspond à la fréquence $F_{LO\_CH1}$, et une deuxième raie principale à la fréquence $F_B$+$F_2$ qui correspond à la fréquence $F_{LO\_CH2}$. Ce deuxième signal multi-tonalités est envoyé à l'entrée d'un troisième circuit récupérateur de fréquence 438 rejetant les fréquences autres que la fréquence $F_{LO\_CH1}$ et délivrant en sortie le signal de fréquence $F_{LO\_CH1}$, et à l'entrée d'un quatrième circuit récupérateur de fréquence 440 rejetant les fréquences autres que la fréquence $F_{LO\_CH2}$ et délivrant en sortie le signal de fréquence $F_{LO\_CH2}$.

Les circuits récupérateurs de fréquence 432, 434, 438 et 440 comportent des ILO commutables aptes à se verrouiller à la fréquence souhaitée et à délivrer en sortie les signaux périodiques de fréquences souhaitées. Un ILO commutable agit à la fois comme un filtre passe-bande très sélectif et comme un régénérateur de signal, par le biais du verrouillage réalisé sur la fréquence souhaitée.

Les circuits récupérateurs de fréquence 432, 434, 438 et 440 jouent chacun un rôle de filtre passe-bande de très haute sélectivité, et peuvent correspondre chacun à un ILO commutable ou plusieurs circuits ILO commutables disposés en cascade.

Ainsi, on obtient en sortie du dispositif 400 des signaux $S_{LO\_IF1}$, $S_{LO\_IF2}$, et $S_{LO\_CH1}$ à $S_{LO\_CHm}$ de spectre pur, c'est-à-dire comportant une unique raie à la fréquence souhaitée, dont la phase est verrouillée sur celle du signal de référence de fréquence $F_{ref}$, toutes les autres composantes non désirées ayant été rejetées en dehors des spectres fréquentiels de ces signaux par les circuits récupérateurs de fréquence 432, 434, 438 et 440. Toutefois, la réjection des raies adjacentes à la raie principale n'est pas infinie en pratique. Ainsi, les signaux $S_{LO\_IF1}$, $S_{LO\_IF2}$, et $S_{LO\_CH1}$ à $S_{LO\_CHm}$ obtenus en sortie des circuits récupérateurs de fréquence 432, 434, 438 et 440 peuvent correspondre non pas à des signaux sinusoïdaux purs, mais à des signaux périodiques dont les spectres fréquentiels présentent chacun une raie principale à la fréquence souhaitée ainsi que des raies secondaires se trouvant à des fréquences multiples de celle de la raie principale. Il est possible d'augmenter cette réjection en reliant en cascade (c'est-à-dire en série) un ILO commutable avec un ou plusieurs ILO, commutable ou non, et/ou un ou plusieurs filtres passe-bande pour former chacun des circuits récupérateurs de fréquence 432, 434, 438 et 440, et atténuer ainsi encore plus les raies secondaires des spectres fréquentiels des signaux obtenus en sortie de ces circuits.

La figure 20 représente une variante de réalisation de la première PLL 402. Dans cette variante de réalisation, l'entrée du deuxième diviseur de fréquence 414 n'est pas reliée à la sortie du premier diviseur de fréquence 412, mais est reliée à la sortie de l'oscillateur 410. Dans cette configuration, les fréquences $F_A$ et $F_B$ sont telles que $F_B = F_A/N1$ et $F_{ref} = F_A/N2 = F_B.N1/N2$.

La figure 21 représente une variante de réalisation de la deuxième PLL 416. Dans cette variante de réalisation, l'entrée du quatrième diviseur de fréquence 428 n'est pas reliée à la sortie du troisième diviseur de fréquence 426, mais est reliée à la sortie de l'oscillateur 424. Dans cette configuration, les fréquences $F_1$ et $F_2$ sont telles que $F_2 = F_1/N3$ et $F_{ref} = F_1/N4 = F_2.N3/N4$.

Les composants des PLL 402 et 416 sont choisis et dimensionnés tels que les fréquences $F_A$, $F_B$, $F_1$ et $F_2$ des signaux générés soient adaptées aux canaux des bandes basse et haute de fréquences de transmission utilisés. En effet, en considérant la bande basse de fréquences de transmission, les fréquences $F_A$ et $F_B$ sont telles que $F_{CLA} = F_A$-$F_1$+$F_{IF}$ et $F_{IF} = F_B = F_A/N1$. La fréquence $F_A$ est donc telle que $F_A = N1.(F_{CLA} + F_1)/(N1 + 1)$. En considérant la bande haute des fréquences de transmission, les fréquences $F_A$ et $F_B$ peuvent également être caractérisées telles que $F_{CUA} = F_A$+$F_1$+$F_{IF}$, avec toujours $F_{IF} = F_B = F_A/N1$. La fréquence $F_A$ est donc également telle que $F_A = N1.(F_{CUA} - F_1)/(N1 + 1)$. Les valeurs de $F_{CLA}$, $F_{CUA}$, $F_1$ et $F_2$ correspondent à des spécifications découlant de la configuration des canaux (nombre, largeur) utilisés dans les bandes de fréquences d'émission et de réception. Par exemple, dans le cas d'une transmission de type E-band avec de canaux de largeur égale à 1 GHz ou 2 GHz (correspondant aux exemples décrits en liaison avec la figure 17), ces fréquences sont $F_{CLA} = 73,375$ GHz, $F_{CUA} = 83,375$ GHz, $F_1 = 5$ GHz, et $F_2 = 1,25$ GHz.

En variante, il est possible que le dispositif 400 comporte, à la place des deux PLL 402 et 416, une seule PLL pour générer les signaux de fréquences $F_A$, $F_B$, $F_1$ et $F_2$. Une telle configuration est possible lorsque les valeurs de $F_A$, $F_B$, $F_1$ et $F_2$ ont un diviseur commun autre que 1.

Les principes ci-dessus s'appliquent lorsque deux canaux sont répartis dans chacune des bandes de fréquences de transmission, mais également lorsque plus de deux canaux sont répartis dans chacune de ces bandes dès lors que leurs fréquences centrales sont distribuées de manière symétrique à l'intérieure de chaque bande de fréquences de transmission. Dans ce cas, le deuxième signal multi-tonalités obtenu en sortie du deuxième élément 436 est utilisé pour générer plus de deux signaux périodiques de fréquences différentes.

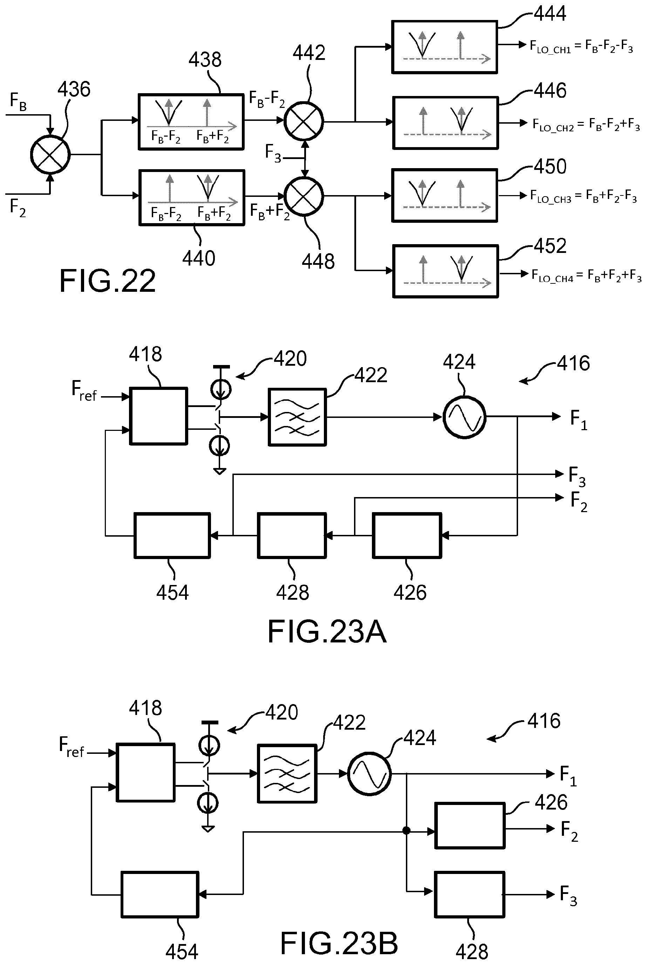

La figure 22 représente une partie du dispositif 400 dans lequel le deuxième signal multi-tonalités obtenu à partir des signaux périodiques de fréquences $F_B$ et $F_2$ permet la génération de plus de deux signaux périodiques de fréquences différentes (quatre sur l'exemple de la figure 22).

Comme dans l'exemple précédemment décrit, les signaux de fréquences $F_B$ et $F_2$ sont appliqués en entrée du deuxième élément 436 (ici un mélangeur). Le deuxième signal multi-tonalités obtenu en sortie du deuxième élément 436 est appliqué en entrée des deux circuits récupérateurs de fréquence 438 et 440 (ici des ILO commutables) délivrant en sortie les signaux de fréquences $F_B$-$F_2$ et $F_B$+$F_2$. Le signal délivré en sortie du troisième circuit récupérateur de fréquence 438 est appliqué en entrée d'un troisième élément 442 (ici un mélangeur) réalisant une opération non linéaire entre le signal de fréquence $F_B-F_2$ et un signal périodique (par exemple sinusoïdal) de fréquence $F_3$ et générant un troisième signal multi-tonalités dont le spectre fréquentiel comporte deux raies principales aux fréquences $F_B-F_2-F_3$ et $F_B-F_2+F_3$. Ce troisième signal multi-tonalités est alors appliqué en entrée d'un cinquième circuit récupérateur de fréquence 444 (ici un ILO commutable) rejetant du spectre fréquentiel les fréquences autres que la fréquence $F_B-F_2-F_3$ et délivrant en sortie un signal périodique de fréquence $F_{LO\_CH1} = F_B-F_2-F_3$, ainsi qu'en entrée d'un sixième circuit récupérateur de fréquence 446 rejetant du spectre fréquentiel les fréquences autres que la fréquence $F_B-F_2+F_3$ et délivrant en sortie un signal périodique de fréquence $F_{LO\_CH2} = F_B-F_2+F_3$. Parallèlement à cela, le signal délivré en sortie du quatrième circuit récupérateur de fréquence 440 est appliqué en entrée d'un quatrième élément 448 (ici un mélangeur) réalisant une opération non linéaire entre le signal de fréquence $F_B+F_2$ et le signal de fréquence $F_3$ et générant un quatrième signal multi-tonalités dont le spectre fréquentiel comporte deux raies principales aux fréquences $F_B+F_2-F_3$ et $F_B+F_2+F_3$. Ce quatrième signal multi-tonalités est alors appliqué en entrée d'un septième circuit récupérateur de fréquence 450 (ici un ILO commutable) rejetant du spectre fréquentiel les fréquences autres que la fréquence $F_B+F_2-F_3$ et délivrant en sortie le signal de fréquence $F_{LO\_CH3} = F_B+F_2-F_3$, ainsi qu'en entrée d'un huitième circuit récupérateur de fréquence 452 rejetant du spectre fréquentiel les fréquences autres que la fréquence $F_B+F_2+F_3$ et délivrant en sortie le signal de fréquence $F_{LO\_CH4} = F_B+F_2+F_3$. Au moins un des circuits récupérateurs de fréquence 438, 440, 444, 446, 450 et 452 est un ILO commutable. Le ou les circuits qui ne sont pas des ILO commutables peuvent être des ILO non commutables ou des filtres passe-bande.

La valeur de $F_3$ est choisie en fonction des valeurs des fréquences $F_{LO\_CH1}$ à $F_{LO\_CHm}$ souhaitées.

Si la fréquence $F_3$ a un diviseur commun avec les fréquences $F_1$ et $F_2$, le signal périodique de fréquence $F_3$ peut être généré à partir de la deuxième PLL 416 qui comporte dans ce cas un diviseur de fréquence 454 supplémentaire réalisant une division de fréquence d'un facteur N5, comme c'est le cas sur les exemples de réalisation de la deuxième PLL 416 représentés sur les figures 23A et 23B. Dans la configuration représentée sur la figure 23A, les fréquences $F_1$, $F_2$ et $F_3$ sont telles que : $F_2 = F_1/N3$, $F_3 = F_2/N4$ et $F_{ref} = F_3/N5 = F_2/(N4.N5) = F_1/(N3.N4.N5)$. Dans la configuration représentée sur la figure 23B, les fréquences $F_1$, $F_2$, $F_3$ sont telles que : $F_2 = F_1/N3$, $F_3 = F_1/N4$ et $F_{ref} = F_1/N5 = F_2.N3/N5 = F_3.N4/N5$.

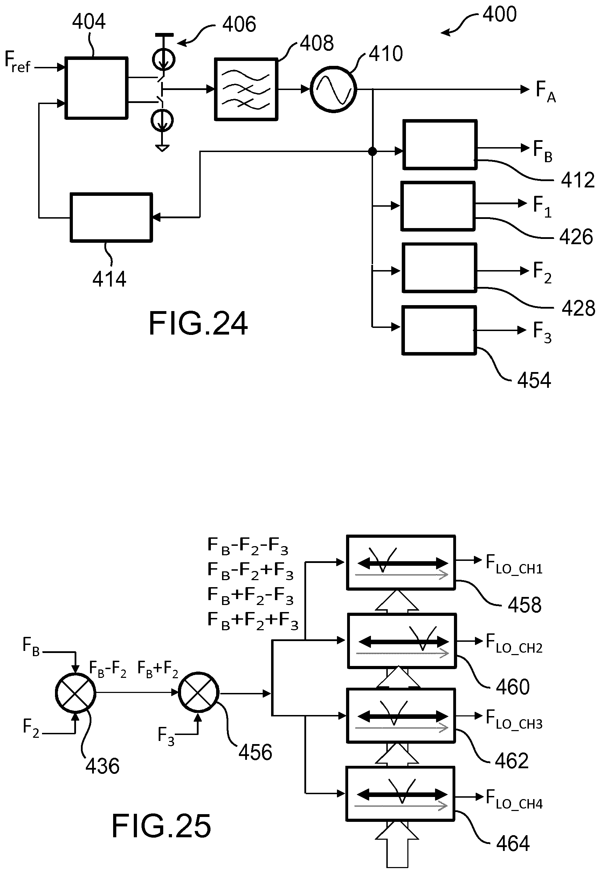

Il est également possible dans ce cas que le dispositif 400 comporte une seule PLL pour générer les signaux de fréquence $F_A$, $F_B$, $F_1$, $F_2$ et $F_3$. Une telle configuration est possible lorsque les valeurs de $F_A$, $F_B$, $F_1$, $F_2$ et $F_3$ ont toutes un diviseur commun. Une telle configuration est représentée sur la figure 24. Dans cette configuration, les valeurs de ces fréquences sont telles que $F_B = F_A/N1$, $F_1 = F_A/N2$, $F_2 = F_A/N3$, $F_3 = F_A/N4$, et $F_{ref} = F_A/N5$. D'autres configurations des diviseurs de fréquences 412, 414, 426, 428 et 454 sont possibles tout en n'ayant qu'une seule PLL pour générer ces signaux périodiques.

Si plus de quatre signaux périodiques de fréquences différentes sont destinés à être générés pour la transposition de fréquence entre la bande de fréquences intermédiaires et la bande de base (plus de quatre canaux dans chaque bande de fréquences de transmission), les signaux obtenus en sortie d'au moins une partie des circuits récupérateurs de fréquence 444, 446, 450 et 452 peuvent être de nouveau envoyés en entrée d'un ou plusieurs éléments réalisant des opérations non linéaires afin de générer de nouveaux signaux multi-tonalités à partir desquels un plus grand nombre de signaux périodiques de fréquences différentes peuvent être obtenus en sortie d'autres éléments récupérateurs de fréquence, sur la base du même principe que celui décrit ci-dessus en liaison avec la figure 22.

De manière générale, dans le cas d'un dispositif de type E-band, les différents composants peuvent être dimensionnés de différentes manières, notamment en fonction de la valeur de N1 choisie. Toutefois, toutes les valeurs possibles de N1 ne sont pas judicieuses car il faut tenir compte du fait que la fréquence $F_{IF}$ doit être de préférence supérieure à la largeur des bandes de fréquences de transmission (5 GHz dans le cas de l'E-Band) d'un facteur compris entre environ 3 et 10 afin de faciliter la réalisation du dispositif 400. Cela signifie que les grandes valeurs de N1 peuvent dans ce cas être écartées. En outre, une valeur de N1 trop faible engendre des fréquences $F_A$ et $F_B$ proches, ce qui est moins intéressant. Le tableau ci-dessous donne les valeurs des fréquences $F_A$ et $F_B$, ainsi que le rapport entre la fréquence $F_B$ et la largeur de la bande de fréquences intermédiaires (5 GHz dans l'exemple décrit ici), pour différentes valeurs de N1, et pour $F_A = N1.(F_{CLA} + F_1)/(N1 + 1)$ avec $F_{CLA} = 73,375$ GHz et $F_1 = 5$ GHz.

| N1 | $F_A$ (GHz) | $F_B$ (GHz) | $F_B$ / BW(IF) |
|---|---|---|---|
| 1 | 39,185 | 39,185 | 7,84 |
| 2 | 52,250 | 26,125 | 5,22 |
| 3 | 58,781 | 19,593 | 3,91 |
| 4 | 62,700 | 15,675 | 3,13 |
| 5 | 65,312 | 13,062 | 2,61 |

(suite)

| N1 | $F_A$ (GHz) | $F_B$ (GHz) | $F_B$ / BW(IF) |
|---|---|---|---|
| 6 | 67,178 | 11,190 | 2,24 |
| 7 | 68,578 | 9,796 | 1,959 |

La valeur de N1 peut être avantageusement choisie telle qu'elle soit égale à 2, 3 ou 4. Par exemple, pour N1 = 4, les valeurs des fréquences centrales de quatre canaux CH1 à CH4 de largeur égale à 1 GHz dans chaque bande de fréquences de transmission et dans la bande de fréquences intermédiaires sont données dans le tableau ci-dessous. En bande de base, les fréquences centrales des canaux sont égales à 0 en émission et en réception.

| | CH1 | CH2 | CH3 | CH4 |
|---|---|---|---|---|
| Fréquence centrale dans la bande de fréquences intermédiaires (GHz) | 13,925 | 14,925 | 16,425 | 17,425 |
| Fréquence centrale dans la bande basse de fréquences de transmission (GHz) | 71,625 | 72,625 | 74,125 | 75,125 |
| Fréquence centrale dans la bande haute de fréquences de transmission (GHz) | 81,625 | 82,625 | 84,125 | 85,125 |

Egalement dans le cas où N1 = 4, les valeurs des fréquences centrales de deux canaux CH1 et CH2 de largeur égale à 2 GHz sont données ci-dessous dans la bande de fréquences intermédiaires et dans les bandes de fréquences de transmission. En bande de base, les fréquences centrales des canaux sont égales à 0 en émission et en réception.

| | CH1 | CH2 |
|---|---|---|
| Fréquence centrale dans la bande de fréquences intermédiaires (GHz) | 14,425 | 16,925 |
| Fréquence centrale dans la bande basse de fréquences de transmission (GHz) | 72,125 | 74,625 |
| Fréquence centrale dans la bande haute de fréquences de transmission (GHz) | 82,125 | 84,625 |

On décrit ci-dessous un exemple de réalisation du dispositif 400 tel que représenté sur la figure 19 réalisant une transmission dans les bandes 71-76 GHz et 81-86 GHz avec des canaux de largeur égale à 2 GHz (deux canaux dans chaque bande de transmission).

Le résonateur génère un signal sinusoïdal de fréquence $F_{ref}$ = 25 MHz. L'oscillateur 410 est un VCO générant un signal sinusoïdal de fréquence $F_A$ = 62,7 GHz. Le premier diviseur de fréquence 412 réalise une division d'un facteur N1 = 4 de la fréquence $F_A$, délivrant ainsi en sortie un signal sinusoïdal de fréquence $F_B$ = 15,675 GHz. Le deuxième diviseur de fréquence 414 réalise une division de fréquence de facteur N2 = 627, délivrant ainsi en sortie un signal sinusoïdal de fréquence égale à 25 MHz.

La deuxième PLL 416 utilise le même signal de fréquence $F_{ref}$ = 25 MHz que celui utilisé dans la première PLL 402. Le deuxième oscillateur 424 est un VCO générant un signal sinusoïdal de fréquence $F_1$ = 5 GHz. Le troisième diviseur de fréquence 426 réalise une division d'un facteur N3 = 4 de la fréquence $F_1$, délivrant ainsi en sortie un signal sinusoïdal de fréquence $F_2$ = 1,25 GHz. Le quatrième diviseur de fréquence 428 réalise une division de fréquence de facteur N4 = 50, délivrant ainsi en sortie un signal sinusoïdal de fréquence égale à 25 MHz.

Les éléments 430 et 436 sont des mélangeurs. Les signaux de sortie de ces mélangeurs sont envoyés en entrée des circuits récupérateurs de fréquence 432, 434, 438 et 440 correspondant à des ILO commutables. Le premier circuit récupérateur de fréquence 432 délivre en sortie un signal sensiblement sinusoïdal de fréquence $F_{LO\_IF2}$ = 57,7 GHz. Le deuxième circuit récupérateur de fréquence 434 délivre en sortie un signal sensiblement sinusoïdal de fréquence $F_{LO\_IF1}$ = 67,7 GHz. Le troisième circuit récupérateur de fréquence 438 délivre en sortie un signal sensiblement sinusoïdal de fréquence $F_{LO\_CH1}$ = 14,425 GHz. Le quatrième circuit récupérateur de fréquence 440 délivre en sortie un signal sensiblement sinusoïdal de fréquence $F_{LO\_CH2}$ = 16,925 GHz.

Pour la réalisation d'un dispositif 400 réalisant une transmission dans les bandes 71 - 76 GHz et 81 - 86 GHz avec des canaux de largeur égale à 1 GHz (quatre canaux dans chaque bande de fréquences de transmission), l'ensemble des éléments décrits ci-dessus sont utilisés et couplés à ceux précédemment décrits en liaison avec la figure 22. Le troisième élément 442 est un mélangeur recevant en entrée le signal de fréquence égale à 14,425 GHz ainsi qu'un signal sinusoïdal de fréquence $F_3$ = 500 MHz, et le quatrième élément 448 est également un mélangeur recevant en entrée le signal de fréquence égale à 16,925 GHz ainsi que le signal de fréquence $F_3$. Les signaux de sortie de ces mélangeurs sont envoyés en entrée des autres circuits récupérateurs de fréquence 444, 446, 450 et 452 correspondant à des ILO commutables. Le cinquième circuit récupérateur de fréquence 444 délivre en sortie un signal sensiblement sinusoïdal de fréquence $F_{LO\_CH1}$ = 13,925 GHz. Le sixième circuit récupérateur de fréquence 446 délivre en sortie un signal sensiblement sinusoïdal de fréquence $F_{LO\_CH2}$ = 14,925 GHz. Le septième circuit récupérateur de fréquence 450 délivre en sortie un signal sensiblement sinusoïdal de fréquence $F_{LO\_CH3}$ = 16,425 GHz. Le huitième circuit récupérateur de fréquence 452 délivre en sortie un signal sensiblement sinusoïdal de fréquence $F_{LO\_CH4}$ = 17,425 GHz.

Dans les différents exemples et modes de réalisation précédemment décrits, les éléments récupérateurs de fréquence 432 et 434 générant les signaux de fréquence $F_{LO\_IF2}$ et $F_{LO\_IF1}$ peuvent correspondre à des ILO commutables pouvant se verrouiller sur l'une ou l'autre des deux fréquences du signal multi-tonalités appliqué en entrée de ces éléments, en fonction d'un signal de commande appliqué en entrée de ces ILO commutables. Ainsi, il est possible d'inverser aisément et rapidement les bandes de fréquences utilisés pour l'émission et la réception des données dans le dispositif 2000, ce qui est très avantageux dans le cas de dispositif de transmission de type E-band et autres FDD.

Il est également possible que les éléments de sélection générant les signaux $S_{LO\_CHi}$ correspondent à des ILO commutables, c'est-à-dire comportent un mécanisme leur permettant de modifier leur plage de verrouillage, et donc de se verrouiller sur l'une des fréquences du spectre du signal multi-tonalités selon la configuration dans laquelle se trouve chaque ILO commutable. Le signal obtenu en sortie d'un ILO commutable est donc un signal périodique stable en fréquence, par exemple sinusoïdal ou sensiblement sinusoïdal, dont le spectre fréquentiel comporte une seule raie principale à la fréquence souhaitée selon la configuration dans laquelle est mis l'ILO commutable. Cela permet, d'un point de vue fréquentiel, d'intervertir la position des canaux si cela est nécessaire. Lorsque chaque bande de fréquences de transmission comporte plus de deux canaux, par exemple quatre canaux, l'utilisation d'ILO commutables permet de réduire le nombre de composants servant à générer les signaux $S_{LO\_CHi}$, comme représenté par exemple sur la figure 25. Contrairement à l'exemple de réalisation précédemment décrit en liaison avec la figure 22 dans lequel le signal de sortie du deuxième élément 436 est appliqué en entrée des troisième et quatrième éléments récupérateurs de fréquence 438 et 440, le signal de sortie du deuxième élément 436 appliqué sur l'entrée d'un autre élément 456, par exemple un mélangeur, réalisant une opération non linéaire entre le signal multi-tonalités comportant les fréquences $F_B$-$F_2$ et $F_B$+$F_2$ et le signal de fréquence $F_3$. Ainsi, le signal multi-tonalités obtenu en sortie de l'élément 456 comporte dans son spectre quatre raies principales aux fréquences $F_{LO\_CHi}$, c'est-à-dire les fréquences $F_B$-$F_2$-$F_3$, $F_B$-$F_2$+$F_3$, $F_B$+$F_2$-$F_3$ et $F_B$+$F_2$+$F_3$. Ce signal multi-tonalités est alors appliqué sur l'entrée des quatre ILO commutables 458, 460, 462 et 464 chacun apte à se verrouiller sur l'une de ces fréquences et délivrer en sortie un signal sensiblement sinusoïdal de fréquence égale à l'une de ces quatre fréquences. L'ensemble des positions fréquentielles des canaux peuvent être permutées les unes par rapport aux autres selon la valeur des signaux de commande appliqués sur les entrées de commande de ces ILO commutables. Il est également possible qu'une même fréquence soit sélectionnée par plusieurs des ILO commutables, par exemple dans le cas d'un émetteur ou d'un récepteur travaillant sur un seul canal à la fois qui peut être sélectionné entre les canaux alloués dans la bande couverte par le générateur de fréquences.

Dans les différents exemples de réalisation précédemment décrits, les signaux multi-tonalités comportent des raies principales (correspondant aux fréquences destinées à être récupérées par les circuits récupérateurs de fréquence) d'amplitudes similaires et/ou en phase les unes avec les autres, ce qui permet aux signaux périodiques générés d'avoir des amplitudes et/ou des phases sensiblement constantes quelque soit la fréquence sur laquelle chaque ILO est verrouillé. Le fait que les raies correspondant aux fréquences destinées à être récupérées soient des raies principales du spectre fréquentiel des signaux multi-tonalités (raies de plus grande amplitude par rapport aux raies voisines) facilite le verrouillage des ILO sur ces raies et évite un verrouillage sur une éventuelle autre raie du spectre fréquentiel de ces signaux. La caractéristique selon laquelle les raies principales ont des amplitudes sensiblement similaires peut correspondre à une différence en tension d'environ 4 dB maximum entre ces amplitudes.

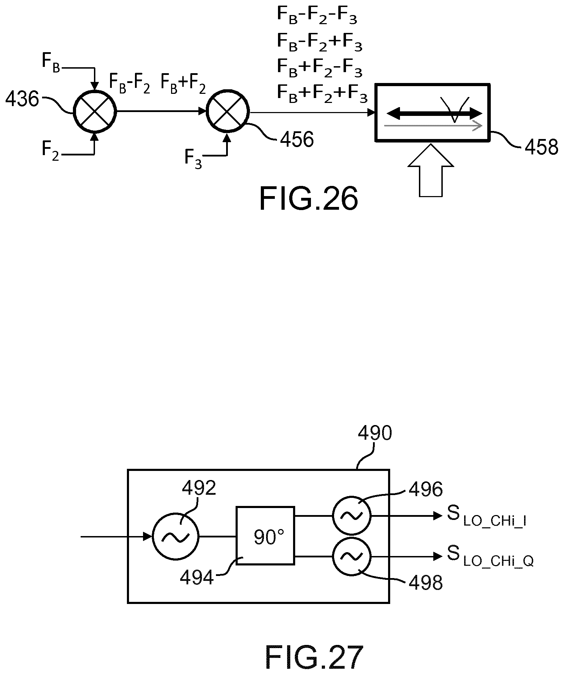

L'utilisation d'ILO commutables peut également être envisagée pour la réalisation de canaux de fréquence variable, comme représenté sur la figure 26. Sur cette figure, un seul ILO commutable 458 est utilisé car le dispositif 2000 est destiné à fonctionner avec un seul canal dont la fréquence centrale peut changer. Ainsi, la fréquence du signal de sortie délivré par cet ILO commutable 458 peut correspondre à l'une des quatre fréquences que comporte le signal multi-tonalités délivré par l'élément 456.

La figure 27 représente un exemple de réalisation d'un circuit récupérateur de fréquence 490 permettant de délivrer en sortie de tels signaux. Le circuit 490 reçoit en entrée le signal multi-tonalités comportant dans son spectre la fréquence $F_{LO\_CHi}$ correspondant par exemple l'une des deux fréquences $F_B$-$F_2$ et $F_B$+$F_2$. Le circuit 490 comporte un premier ILO commutable 492 dont l'entrée reçoit le signal multi-tonalités et dont la sortie est reliée à l'entrée d'un élément déphaseur 494 de type actif ou passif permettant de reproduire sur l'une de ses deux sorties le signal appliqué en entrée et de générer sur l'autre de ses deux sorties le signal appliqué en entrée déphasé de 90°. Chacun de ces deux signaux sont appliqués en entrées de deux autres ILO, commutables ou non, 496 et 498 délivrant en sortie les signaux $S_{LO\_CHi\_I}$ et $S_{LO\_CHi\_Q}$. Les deux ILO 496 et 498 fonctionnent soit de manière indépendante l'un de l'autre, soit de manière couplée telle que les sorties des deux ILO 496 et 498 soient déphasées l'une de l'autre de 90° sans faire appel à l'élément déphaseur 494. Le fonctionnement d'un tel élément de type Quadrature VCO (QVCO) est par exemple décrit dans le document « A 17.5-to-20.94GHz and 35-to-41.88GHz PLL in 65nm CMOS for wireless HD applications »

**EP 3 005 568 B1**

de O. Richard et al., Solid-States Circuits Conférence Digest of Technical Papers (ISSCC), 2010 IEEE International, pages 252-253, 7-11 Feb. 2010.

## Revendications

1. Dispositif (100, 200, 300, 400) de génération d'au moins un signal périodique stable en fréquence, comportant au moins :

   - un générateur (102, 402, 416) apte à générer au moins un premier signal périodique dont le spectre fréquentiel comporte au moins deux raies à des fréquences $f_a$ et $f_b$ différentes ;
   - un premier oscillateur verrouillé par injection commutable (104, 104.1, 104.2, 104.3, 432, 434, 438, 440, 444, 446, 450, 452, 458, 460, 462, 464, 492) apte à recevoir en entrée le premier signal périodique et à se verrouiller, dans un premier état, sur la fréquence $f_a$, et dans un deuxième état, sur la fréquence $f_b$, en fonction de la valeur d'au moins un signal de commande appliqué en entrée du premier oscillateur verrouillé par injection commutable (104, 104.1, 104.2, 104.3, 432, 434, 438, 440, 444, 446, 450, 452, 458, 460, 462, 464, 492).

2. Dispositif (100, 200, 300, 400) selon la revendication 1, dans lequel les raies aux fréquences $f_a$ et $f_b$ ont des amplitudes sensiblement similaires et/ou sont en phase l'une avec l'autre et/ou correspondent à deux raies principales du spectre fréquentiel du premier signal périodique.

3. Dispositif (100, 200, 300, 400) selon l'une des revendications précédentes, dans lequel le premier oscillateur verrouillé par injection commutable (104, 104.1, 104.2, 104.3, 432, 434, 438, 440, 444, 446, 450, 452, 458, 460, 462, 464, 492) comporte au moins :

   - une structure résonante (130) apte à générer un deuxième signal périodique oscillant, dans le premier état, à une première fréquence d'oscillation libre, et dans le deuxième état, à une deuxième fréquence d'oscillation de valeur différente de celle de la première fréquence d'oscillation libre ;
   - un élément électrique (132) couplé électriquement à la structure résonante (130) et dont une impédance est équivalente à celle d'une résistance électrique négative ;
   - un circuit d'injection (134) couplé électriquement au dit élément électrique (132), recevant en entrée le premier signal périodique et apte à fournir ledit élément électrique (132) avec un courant de fréquence égale à celle du premier signal périodique.

4. Dispositif (100, 200, 300, 400) selon la revendication 3, dans lequel la structure résonante (130) du premier oscillateur verrouillé par injection commutable (104, 104.1, 104.2, 104.3, 432, 434, 438, 440, 444, 446, 450, 452, 458, 460, 462, 464, 492) comporte au moins un circuit résonant LC comprenant les composants suivants :

   - une inductance (140) couplée en parallèle, dans le premier état, à un premier condensateur (142) ou, dans le deuxième état, à un deuxième condensateur (144) ayant une capacité électrique de valeur différente de celle du premier condensateur (142), ou
   - un condensateur couplé en parallèle, dans le premier état, à une première inductance ou, dans le deuxième état, à une deuxième inductance de valeur différente de celle de la première inductance, ou
   - dans le premier état, une première inductance couplée en parallèle à un premier condensateur ou, dans le deuxième état, une deuxième inductance couplée en parallèle à un deuxième condensateur, la première inductance ayant une valeur différente de celle de la deuxième inductance et le premier condensateur ayant une capacité électrique de valeur différente de celle du deuxième condensateur,

   et comportant en outre des éléments de commutation (146) aptes à modifier les couplages des composants (140, 142, 144) du circuit résonant LC en fonction du signal de commande.

5. Dispositif (100, 200, 300, 400) selon l'une des revendications 3 ou 4, dans lequel l'élément électrique (132) du premier oscillateur verrouillé par injection commutable (104, 104.1, 104.2, 104.3, 432, 434, 438, 440, 444, 446, 450, 452, 458, 460, 462, 464, 492) comporte une paire croisée différentielle de type MOS.

6. Dispositif (100, 200, 300, 400) selon l'une des revendications 3 à 5, dans lequel le circuit d'injection (134) du premier oscillateur verrouillé par injection commutable (104, 104.1, 104.2, 104.3, 432, 434, 438, 440, 444, 446, 450, 452, 458, 460, 462, 464, 492) comporte au moins :

- un condensateur (150) comportant une première borne sur laquelle le premier signal périodique est destiné à être appliqué ;
- une résistance (152) comportant une première borne sur laquelle une tension de polarisation continue est destinée à être appliquée et une deuxième borne reliée électriquement à une deuxième borne du condensateur (150) ;
- un transistor MOS (154) dont une grille est reliée électriquement à la deuxième borne du condensateur (150) et dont un drain est relié électriquement à l'élément électrique (132) de l'oscillateur verrouillé par injection commutable (104, 104.1, 104.2, 104.3, 432, 434, 438, 440, 444, 446, 450, 452, 458, 460, 462, 464, 492).

7. Dispositif (100, 200, 300, 400) selon l'une des revendications précédentes, dans lequel le générateur (102, 402, 416) comporte :

   - une boucle à verrouillage de phase délivrant un troisième signal périodique de fréquence $f_1$ et un quatrième signal périodique de fréquence $f_2 = f_1/N_1$, avec $N_1$ supérieur à 1 ;
   - un mélangeur de fréquences (120, 430, 436) recevant en entrée le troisième signal périodique et le quatrième signal périodique et délivrant en sortie le premier signal périodique tel $f_a = f_1 - f_2$ et $f_b = f_1 + f_2$.

8. Dispositif (100, 200, 300) selon l'une des revendications 1 à 6, dans lequel le générateur (102) comporte :

   - une boucle à verrouillage de phase (106, 108, 110, 112, 114, 116, 118) délivrant un troisième signal périodique de fréquence $f_1$;
   - des moyens (122.1, 122.2, 124.1, 124.2) aptes à recevoir en entrée le signal périodique de fréquence $f_1$ et à générer au moins deux signaux $S_{G1}$ et $S_{G2}$ en phase l'un avec l'autre et correspondant chacun à un train d'oscillations de fréquence sensiblement égale à $f_a$ et $f_b$ respectivement, de durée inférieure à $T_1 = 1/f_1$ et répété périodiquement à la fréquence $f_1$,
   - un additionneur (126) apte à délivrer en sortie le premier signal périodique correspondant à la somme des signaux $S_{G1}$ et $S_{G2}$.

9. Dispositif (100, 200, 300) selon la revendication 8, dans lequel lesdits moyens du générateur (102) comportent au moins deux oscillateurs commandés en tension (122.1, 122.2) dont des plages d'oscillation libre incluent les fréquences $f_a$ et $f_b$ respectivement, et au moins deux interrupteurs (124.1, 124.2) reliés à des entrées d'alimentation électrique des oscillateurs commandés en tension (122.1, 122.2) et aptes à être commandés par le signal périodique de fréquence $f_1$ tels qu'ils génèrent des tensions d'alimentation des oscillateurs commandés en tension (122.1, 122.2) non nulles seulement pendant une partie de chaque période $T_1$ ou au moins deux interrupteurs relié à des sorties des oscillateurs commandés en tension (122.1, 122.2) et aptes à être commandés par le signal périodique de fréquence $f_1$ tels qu'ils coupent des liaisons électriques entre les sorties des oscillateurs commandés en tension (122.1, 122.2) et des entrées de l'additionneur (126) pendant une partie de chaque période $T_1$.

10. Dispositif (200, 300, 400) selon l'une des revendications précédentes, comportant en outre au moins un deuxième oscillateur verrouillé par injection commutable (104.2, 104.3, 432, 434, 438, 440, 444, 446, 450, 452, 458, 460, 462, 464, 492) apte à recevoir en entrée le premier signal périodique et à se verrouiller dans un premier état sur la fréquence $f_b$ et dans un deuxième état sur la fréquence $f_a$, ou à se verrouiller dans le premier état sur la fréquence $f_a$ et dans le deuxième état sur la fréquence $f_b$, en fonction du signal de commande appliqué en entrée du premier et du deuxième oscillateurs verrouillés par injection commutables (104.1, 104.2, 104.3, 432, 434, 438, 440, 444, 446, 450, 452, 458, 460, 462, 464, 492).

11. Dispositif (200, 300, 400) selon l'une des revendications précédentes, dans lequel le spectre fréquentiel du premier signal périodique comporte au moins n raies à n fréquences différentes, et comportant en outre n oscillateurs verrouillés par injection commutables (104.1, 104.2, 104.3, 432, 434, 438, 440, 444, 446, 450, 452, 458, 460, 462, 464, 492) chacun apte à recevoir en entrée le premier signal périodique et à se verrouiller sur chacune des n fréquences en fonction de la valeur du signal de commande appliqué en entrée des n oscillateurs verrouillés par injection commutables (104.1, 104.2, 104.3, 432, 434, 438, 440, 444, 446, 450, 452, 458, 460, 462, 464, 492), n étant un nombre entier supérieur à 1.

12. Dispositif (200) selon l'une des revendications précédentes, comportant en outre au moins un troisième oscillateur verrouillé par injection commutable (104.4, 104.5) apte à recevoir en entrée un signal de sortie du premier ou du deuxième oscillateur verrouillé par injection commutable (104, 104.1, 104.2) ou de l'un desdits n oscillateurs verrouillés par injection commutables (104, 104.1, 104.2, 104.3), et à se verrouiller sur une fréquence similaire à celle sur laquelle est verrouillé l'oscillateur verrouillé par injection commutable (104, 104.1, 104.2, 104.3) auquel est relié le troisième oscillateur verrouillé par injection commutable (104.4, 104.5).

13. Dispositif d'émission et/ou de réception de signaux (1000, 2000), comportant au moins un dispositif de génération de signal périodique stable en fréquence (100, 200, 300, 400) selon l'une des revendications précédentes couplé à un modulateur (1004, 2026.1 - 2026.m, 2028) et/ou un démodulateur (1014, 2014, 2016.1 - 2016.m) du dispositif d'émission et/ou de réception (1000, 2000).

**Patentansprüche**

1. Vorrichtung (100, 200, 300, 400) zum Erzeugen zumindest eines periodischen, frequenzstabilen Signals, die zumindest enthält:

   - einen Generator (102, 402, 416), der zumindest ein erstes periodisches Signal erzeugen kann, dessen Frequenzspektrum zumindest zwei Linien mit verschiedenen Frequenzen $f_a$ und $f_b$ aufweist,
   - einen ersten umschaltbaren, injektionssynchronisierten Oszillator (104, 104.1, 104.2, 104.3, 432, 434, 438, 440, 444, 446, 450, 452, 458, 460, 462, 464, 492), der am Eingang das erste periodische Signal empfangen und sich in einem ersten Zustand auf die Frequenz $f_a$ und in einem zweiten Zustand auf die Frequenz $f_b$ synchronisieren kann, und zwar in Abhängigkeit von dem Wert zumindest eines Steuersignals, das am Eingang des ersten umschaltbaren, injektionssynchronisierten Oszillators (104, 104.1, 104.2, 104.3, 432, 434, 438, 440, 444, 446, 450, 452, 458, 460, 462, 464, 492) angelegt wird.

2. Vorrichtung (100, 200, 300, 400) nach Anspruch 1, wobei die Linien mit den Frequenzen $f_a$ und $f_b$ im Wesentlichen ähnliche Amplituden haben und/oder in Phase miteinander sind und/oder zwei Hauptlinien des Frequenzspektrums des ersten periodischen Signals entsprechen.

3. Vorrichtung (100, 200, 300, 400) nach einem der vorangehenden Ansprüche, wobei der erste umschaltbare, injektionssynchronisierte Oszillator (104, 104.1, 104.2, 104.3, 432, 434, 438, 440, 444, 446, 450, 452, 458, 460, 462, 464, 492) zumindest enthält:

   - eine Resonanzstruktur (130), die ein zweites periodisches Signal erzeugen kann, das in dem ersten Zustand mit einer ersten freien Oszillationsfrequenz oszilliert und in dem zweiten Zustand mit einer zweiten Oszillationsfrequenz oszilliert, deren Wert sich von dem der ersten freien Oszillationsfrequenz unterscheidet;
   - ein elektrisches Element (132), das elektrisch mit der Resonanzstruktur (130) gekoppelt ist und dessen Impedanz äquivalent zu der eines negativen, elektrischen Widerstands ist;
   - einen Einspeisekreis (134), der elektrisch mit dem elektrischen Element (132) gekoppelt ist, am Eingang das erste periodische Signal empfängt und dazu geeignet ist, das elektrische Element (132) mit einem Strom gleicher Frequenz wie das erste periodische Signal bereitzustellen.

4. Vorrichtung (100, 200, 300, 400) nach Anspruch 3, wobei die Resonanzstruktur (130) des ersten umschaltbaren, injektionssynchronisierten Oszillators (104, 104.1, 104.2, 104.3, 432, 434, 438, 440, 444, 446, 450, 452, 458, 460, 462, 464, 492) zumindest einen Resonanzkreis LC enthält, die nachfolgende Bauelemente aufweist:

   - eine Induktivität (140), die in dem ersten Zustand parallel mit einem ersten Kondensator (142) bzw. in dem zweiten Zustand parallel mit einem zweiten Kondensator (144) gekoppelt ist, der eine elektrische Kapazität hat, deren Wert sich von dem des ersten Kondensators (142) unterscheidet, oder
   - einen Kondensator, der in dem ersten Zustand parallel mit einer ersten Induktivität bzw. in dem zweiten Zustand parallel mit einer zweiten Induktivität gekoppelt ist, deren Wert sich von dem der ersten Induktivität unterscheidet, oder
   - in dem ersten Zustand eine erste Induktivität, die parallel mit einem ersten Kondensator gekoppelt ist, oder in dem zweiten Zustand eine zweite Induktivität, die parallel mit einem zweiten Kondensator gekoppelt ist, wobei die erste Induktivität einen Wert hat, der sich von dem der zweiten Induktivität unterscheidet, und der erste Kondensator eine elektrische Kapazität hat, deren Wert sich von dem des zweiten Kondensators unterscheidet,

   und ferner Schaltelemente (146) aufweist, die die Kopplungen der Bauelemente (140, 142, 144) des Resonanzkreises LC in Abhängigkeit von dem Steuersignal ändern können.

**5.** Vorrichtung (100, 200, 300, 400) nach einem der Ansprüche 3 oder 4, wobei das elektrische Element (132) des ersten umschaltbaren, injektionssynchronisierten Oszillators (104, 104.1, 104.2, 104.3, 432, 434, 438, 440, 444, 446, 450, 452, 458, 460, 462, 464, 492) ein gekreuztes Differenzpaar vom Typ MOS enthält.

**6.** Vorrichtung (100, 200, 300, 400) nach einem der Ansprüche 3 bis 5, wobei der Einspeisekreis (134) des ersten umschaltbaren, injektionssynchronisierten Oszillators (104, 104.1, 104.2, 104.3, 432, 434, 438, 440, 444, 446, 450, 452, 458, 460, 462, 464, 492) zumindest enthält:

- einen Kondensator (150), der eine erste Anschlussklemme aufweist, an welche das erste periodische Signal angelegt werden soll;
- einen Widerstand (152), der eine erste Anschlussklemme aufweist, an welche eine Gleichstrom-Vorspannung angelegt werden soll, sowie eine zweite Anschlussklemme, die elektrisch mit einer zweiten Anschlussklemme des Kondensators (150) verbunden ist;
- einen MOS-Transistor (154), von dem ein Gate elektrisch mit der zweiten Anschlussklemme des Kondensators (150) verbunden ist und von dem ein Drain elektrisch mit dem elektrischen Element (132) des umschaltbaren, injektionssynchronisierten Oszillators (104, 104.1, 104.2, 104.3, 432, 434, 438, 440, 444, 446, 450, 452, 458, 460, 462, 464, 492) verbunden ist.

**7.** Vorrichtung (100, 200, 300, 400) nach einem der vorangehenden Ansprüche, wobei der Generator (102, 402, 416) enthält:

- eine Phasenregelschleife, die ein drittes periodisches Signal der Frequenz $f_1$ und ein viertes periodisches Signal der Frequenz $f_2 = f_1/N_1$, mit $N_1$ größer als 1, ausgibt;
- einen Frequenzmischer (120, 430, 436), der am Eingang das dritte periodische Signal und das vierte periodische Signal empfängt und am Ausgang das erste periodische Signal ausgibt, so dass $f_a = f_1 - f_2$ und $f_b = f_1 + f_2$.

**8.** Vorrichtung (100, 200, 300) nach einem der Ansprüche 1 bis 6, wobei der Generator (102) enthält:

- eine Phasenregelschleife (106, 108, 110, 112, 114, 116, 118), die ein drittes periodisches Signal der Frequenz $f_1$ ausgibt;
- Mittel (122.1, 122.2, 124.1, 124.2), die am Eingang das dritte periodische Signal der Frequenz $f_1$ empfangen und zumindest zwei Signale $S_{G1}$ und $S_{G2}$ erzeugen können, die miteinander in Phase sind und jeweils einem Schwingungszug der Frequenz im Wesentlichen gleich $f_a$ bzw. $f_b$ mit einer Dauer unter $T_1 = 1/f_1$ entspricht und periodisch wiederholt wird mit der Frequenz $f_1$,
- einen Summierer (126), der am Ausgang das erste periodische Signal ausgeben kann, das der Summe der Signale $S_{G1}$ und $S_{G2}$ entspricht.

**9.** Vorrichtung (100, 200, 300) nach Anspruch 8, wobei die Generatormittel (102) zumindest zwei spannungsgesteuerte Oszillatoren (122.1, 122.2) enthalten, deren freie Oszillationsbereiche die Frequenzen $f_a$ bzw. $f_b$ umfassen, sowie zumindest zwei Schalter (124.1, 124.2), die mit Stromversorgungseingängen der spannungsgesteuerten Oszillatoren (122.1, 122.2) verbunden sind und über das periodische Signal der Frequenz $f_1$ so gesteuert werden können, dass sie Versorgungsspannungen der spannungsgesteuerten Oszillatoren (122.1, 122.2) ungleich null nur während eines Teils einer jeden Periode $T_1$ erzeugen, oder zumindest zwei Schalter, die mit den Ausgängen der spannungsgesteuerten Oszillatoren (122.1, 122.2) verbunden sind und über das periodische Signal der Frequenz $f_1$ so gesteuert werden können, dass sie die elektrischen Verbindungen zwischen den Ausgängen der spannungsgesteuerten Oszillatoren (122.1, 122.2) und den Eingängen des Summierers (126) während eines Teils einer jeden Periode $T_1$ trennen.

**10.** Vorrichtung (200, 300, 400) nach einem der vorangehenden Ansprüche, ferner enthaltend zumindest einen zweiten umschaltbaren, injektionssynchronisierten Oszillator (104.2, 104.3, 432, 434, 438, 440, 444, 446, 450, 452, 458, 460, 462, 464, 492), der am Eingang das erste periodische Signal empfangen und sich in einem ersten Zustand auf die Frequenz $f_b$ und in einem zweiten Zustand auf die Frequenz $f_a$ synchronisieren kann, oder sich in einem ersten Zustand auf die Frequenz $f_a$ und in einem zweiten Zustand auf die Frequenz $f_b$ synchronisieren kann, und zwar in Abhängigkeit von dem Steuersignal, das am Eingang des ersten und des zweiten umschaltbaren, injektionssynchronisierten Oszillators (104.1, 104.2, 104.3, 432, 434, 438, 440, 444, 446, 450, 452, 458, 460, 462, 464, 492) angelegt wird.

**11.** Vorrichtung (200, 300, 400) nach einem der vorangehenden Ansprüche, wobei das Frequenzspektrum des ersten periodischen Signals zumindest n Linien mit n verschiedenen Frequenzen aufweist und ferner n umschaltbare, injektionssynchronisierte Oszillatoren (104.1, 104.2, 104.3, 432, 434, 438, 440, 444, 446, 450, 452, 458, 460, 462, 464, 492) enthält, die jeweils am Eingang das erste periodische Signal empfangen und sich auf jede der n Frequenzen in Abhängigkeit von dem Wert des Steuersignals synchronisieren können, das am Eingang der n umschaltbaren, injektionssynchronisierten Oszillatoren (104.1, 104.2, 104.3, 432, 434, 438, 440, 444, 446, 450, 452, 458, 460, 462, 464, 492) angelegt wird, wobei n eine ganze Zahl größer als 1 ist.

12. Vorrichtung (200) nach einem der vorangehenden Ansprüche, ferner enthaltend zumindest einen dritten umschaltbaren, injektionssynchronisierten Oszillator (104.4, 104.5), der am Eingang ein Ausgangssignal des ersten oder des zweiten umschaltbaren, injektionssynchronisierten Oszillators (104, 104.1, 104.2) oder eines der n umschaltbaren, injektionssynchronisierten Oszillatoren (104, 104.1, 104.2, 104.3) empfangen kann und sich auf eine ähnliche Frequenz wie diejenige synchronisieren kann, auf die der umschaltbare, injektionssynchronisierte Oszillator (104, 104.1, 104.2, 104.3) synchronisiert ist, mit welchem der dritte umschaltbare, injektionssynchronisierte Oszillator (104.4, 104.5) verbunden ist.

13. Vorrichtung zum Senden und/oder Empfangen von Signalen (1000, 2000), enthaltend zumindest eine Vorrichtung zum Erzeugen eines periodischen, frequenzstabilen Signals (100, 200, 300, 400) nach einem der vorangehenden Ansprüche, die mit einem Modulator (1004, 2026.1 - 2026.m, 2028) und/oder mit einem Demodulator (1014, 2014, 2016.1 - 2016.m) der Sende- und/oder Empfangsvorrichtung (1000, 2000) gekoppelt ist.

**Claims**

1. Device (100, 200, 300, 400) for generating at least one frequency-stable periodical signal, including at least:

   - a generator (102, 402, 416) able to generate at least one first periodical signal the frequency spectrum of which includes at least two lines at different frequencies $f_a$ and $f_b$;
   - a first switchable injection-locked oscillator (104, 104.1, 104.2, 104.3, 432, 434, 438, 440, 444, 446, 450, 452, 458, 460, 462, 464, 492) able to receive at the input the first periodical signal and to be locked, in a first state, to the frequency $f_a$, and in a second state, to the frequency $f_b$, as a function of the value of at least one control signal applied at the input of the first switchable injection-locked oscillator (104, 104.1, 104.2, 104.3, 432, 434, 438, 440, 444, 446, 450, 452, 458, 460, 462, 464, 492).

2. Device (100, 200, 300, 400) according to claim 1, wherein the lines at the frequencies $f_a$ and $f_b$ have substantially similar amplitudes and/or are in phase with each other and/or correspond to two main lines of the frequency spectrum of the first periodical signal.

3. Device (100, 200, 300, 400) according to one of the preceding claims, wherein the first switchable injection-locked oscillator (104, 104.1, 104.2, 104.3, 432, 434, 438, 440, 444, 446, 450, 452, 458, 460, 462, 464, 492) includes at least:

   - a resonating structure (130) able to generate a second periodical signal oscillating, in the first state, at a first free oscillation frequency, and in the second state, at a second oscillation frequency with a value different from that of the first free oscillation frequency;
   - an electrical element (132) electrically coupled to the resonating structure (130) and an impedance of which is equivalent to that of a negative electrical resistance;
   - an injection circuit (134) electrically coupled to said electrical element (132), receiving at the input the first periodical signal and able to provide said electrical element (132) with a current having a frequency equal to that of the first periodical signal.

4. Device (100, 200, 300, 400) according to claim 3, wherein the resonating structure (130) of the first switchable injection-locked oscillator (104, 104.1, 104.2, 104.3, 432, 434, 438, 440, 444, 446, 450, 452, 458, 460, 462, 464, 492) includes at least one LC resonating circuit comprising the following components:

   - an inductor (140) coupled in parallel, in the first state, to a first capacitor (142) or, in the second state, to a second capacitor (144) having an electric capacitance with a value different from that of the first capacitor (142), or
   - a capacitor coupled in parallel, in the first state, to a first inductor or, in the second state, to a second inductor with a value different from that of the first inductor, or
   - in the first state, a first inductor coupled in parallel with a first capacitor or, in the second state, a second inductor coupled in parallel to a second capacitor, the first inductor having a value different from that of the second inductor and the first capacitor having an electric capacitance with a value different from that of the second capacitor,

and further including switching elements (146) able to modify the couplings of the components (140, 142, 144) of the LC resonating circuit as a function of the control signal.

5. Device (100, 200, 300, 400) according to one of claims 3 or 4, wherein the electrical element (132) of the first switchable injection-locked oscillator (104, 104.1, 104.2, 104.3, 432, 434, 438, 440, 444, 446, 450, 452, 458, 460, 462, 464, 492) includes an MOS type differential twisted pair.

6. Device (100, 200, 300, 400) according to one of claims 3 to 5, wherein the injection circuit (134) of the first switchable injection-locked oscillator (104, 104.1, 104.2, 104.3, 432, 434, 438, 440, 444, 446, 450, 452, 458, 460, 462, 464, 492) includes at least:

   - a capacitor (150) including a first terminal to which the first periodical signal is intended to be applied;
   - a resistor (152) including a first terminal to which a DC bias voltage is intended to be applied and a second terminal electrically connected to a second terminal of the capacitor (150);
   - an MOS transistor (154) a gate of which is electrically connected to the second terminal of the capacitor (150) and a drain of which is electrically connected to the electrical element (132) of the switchable injection-locked oscillator (104, 104.1, 104.2, 104.3, 432, 434, 438, 440, 444, 446, 450, 452, 458, 460, 462, 464, 492).

7. Device (100, 200, 300, 400) according to one of the preceding claims, wherein the generator (102, 402, 416) includes:

   - a phase-locked loop outputting a third periodical signal with a frequency $f_1$ and a fourth periodical signal with a frequency $f_2 = f_1/N_1$, with $N_1$ higher than 1;
   - a frequency mixer (120, 430, 436) receiving at the input the third periodical signal and the fourth periodical signal and outputting the first periodical signal such that $f_a = f_1 - f_2$ and $f_b = f_1 + f_2$.

8. Device (100, 200, 300) according to one of claims 1 to 6, wherein the generator (102) includes:

   - a phase-locked loop (106, 108, 110, 112, 114, 116, 118) outputting a third periodical signal with a frequency $f_1$;
   - means (122.1, 122.2, 124.1, 124.2) able to receive at the input the periodical signal with a frequency $f_1$ and to generate at least two signals $S_{G1}$ and $S_{G2}$ in phase with each other and each corresponding to a train of oscillations with a frequency substantially equal to $f_a$ and $f_b$ respectively, with a duration lower than $T_1 = 1/f_1$ and periodically repeated at the frequency $f_1$,
   - an adder (126) able to output the first periodical signal corresponding to the sum of the signals $S_{G1}$ and $S_{G2}$.

9. Device (100, 200, 300) according to claim 8, wherein said means of the generator (102) include at least two voltage controlled oscillators (122.1, 122.2) the free oscillation ranges of which include the frequencies $f_a$ and $f_b$ respectively, and at least two switches (124.1, 124.2) connected at power supply inputs of the voltage controlled oscillators (122.1, 122.2) and able to be controlled by the periodical signal with the frequency $f_1$ such that they generate supply non-zero voltages of the voltage controlled oscillators (122.1, 122.2) only for part of each period $T_1$ or at least two switches connected to outputs of the voltage controlled oscillators (122.1, 122.2) and able to be controlled by the periodical signal with the frequency $f_1$ such that they break electrical connections between the outputs of the voltage controlled oscillators (122.1, 122.2) and inputs of the adder (126) for part of each period $T_1$.

10. Device (200, 300, 400) according to one of the preceding claims, further including at least one second switchable injection-locked oscillator (104.2, 104.3, 432, 434, 438, 440, 444, 446, 450, 452, 458, 460, 462, 464, 492) able to receive at the input the first periodical signal and to be locked in a first state to the frequency $f_b$ and in a second state to the frequency $f_a$, or to be locked in the first state to the frequency $f_a$ and in the second state to the frequency $f_b$, as a function of the control signal applied at the input of the first and second switchable injection-locked oscillators (104.1, 104.2, 104.3, 432, 434, 438, 440, 444, 446, 450, 452, 458, 460, 462, 464, 492).

11. Device (200, 300, 400) according to one of the preceding claims, wherein the frequency spectrum of the first periodical signal includes at least n lines with n different frequencies, and further including n switchable injection-locked oscillators (104.1, 104.2, 104.3, 432, 434, 438, 440, 444, 446, 450, 452, 458, 460, 462, 464, 492) each able to receive at the input the first periodical signal and to be locked to each of the n frequencies as a function of the value of the control signal applied the input of the n switchable injection-locked oscillators (104.1, 104.2, 104.3, 432, 434, 438, 440, 444, 446, 450, 452, 458, 460, 462, 464, 492), n being an integer number higher than 1.

12. Device (200) according to one of the preceding claims, further including at least one third switchable injection-locked oscillator (104.4, 104.5) able to receive at the input an output signal of the first or second switchable injection-locked oscillator (104, 104.1, 104.2) or one of said n switchable injection-locked oscillators (104, 104.1,104.2, 104.3), and to be locked to a frequency similar to that to which the switchable injection-locked oscillator (104, 104.1, 104.2, 104.3) is locked to which the third switchable injection-locked oscillator (104.4, 104.5) is connected.

13. Device for transmitting and/or receiving signals (1000, 2000), including at least one device for generating a frequency-stable periodical signal (100, 200, 300, 400) according to one of the preceding claims, coupled to a modulator (1004, 2026.1 - 2026.m, 2028) and/or a demodulator (1014, 2014, 2016.1 - 2016.m) of the transmitting and/or receiving device (1000, 2000).

FIG. 1

FIG. 2

FIG. 3

FIG. 4A

FIG. 5A

FIG.4B

FIG. 5B

FIG. 6

FIG. 7

FIG. 8

FIG. 9

FIG. 10

FIG. 11

Switchable ILOs

FIG. 12

FIG. 13

FIG. 14A    FIG. 14B    FIG. 14C

FIG. 15

FIG.16

FIG.17

FIG.18

FIG.19

FIG.20

FIG.21

EP 3 005 568 B1

FIG.22

FIG.23A

FIG.23B

FIG.24

FIG.25

$F_B-F_2-F_3$
$F_B-F_2+F_3$
$F_B+F_2-F_3$
$F_B+F_2+F_3$

$F_B$

436 ⊗ $F_B-F_2$  $F_B+F_2$ ⊗

$F_2$

$F_3$ 456

458

## FIG.26

490

492 496

90° $S_{LO\_CHi\_I}$

494 498 $S_{LO\_CHi\_Q}$

## FIG.27

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2008285625 A1

**Littérature non-brevet citée dans la description**

- A fully integrated SiGe E-BAND transceiver chipset for broadband point-to-point communication. **O. KATZ et al.** Radio and Wireless Symposium (RWS). IEEE, 15 Janvier 2012, 431-434
- **DE A. SILIGARIS et al.** A 60 GHz UWB impulse radio transmitter with integrated antenna in CMOS65nm SOI technology. *Silicon Monolithic Integrated Circuits in RF Systems (SiRF), 2011 IEEE 11th Topical Meeting,* 17 Janvier 2011, 153-156
- **O. RICHARD et al.** A 17.5-to-20.94GHz and 35-to-41.88GHz PLL in 65nm CMOS for wireless HD applications. *Solid-State Circuits Conférence Digest of Technical Papers (ISSCC), 2010 IEEE International,* 07 Février 2010, 252-253
- **O. RICHARD et al.** A 17.5-to-20.94GHz and 35-to-41.88GHz PLL in 65nm CMOS for wireless HD applications. *Solid-States Circuits Conférence Digest of Technical Papers (ISSCC), 2010 IEEE Internationa,* 07 Février 2010, 252-253